(19) Europäisches Patentamt
European Patent Office
Office européen des brevets

(11) **EP 4 451 044 A1**

(12) **EUROPEAN PATENT APPLICATION**

(43) Date of publication:
**23.10.2024 Bulletin 2024/43**

(21) Application number: **23169010.8**

(22) Date of filing: **20.04.2023**

(51) International Patent Classification (IPC):
***G02F 1/00*** *(2006.01)* ***G02F 1/17*** *(2019.01)*

(52) Cooperative Patent Classification (CPC):
**G02F 1/0018; G02F 1/025;** G02B 6/00;
G02F 1/0155; G03F 7/00

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Black Semiconductor GmbH
52072 Aachen (DE)**

(72) Inventors:
• **Fischbach, Jan David
52072 Aachen (DE)**
• **Huyghebaert, Cedric
52072 Aachen (DE)**

(74) Representative: **Herzog IP Patentanwalts GmbH
Steinstraße 16-18
40212 Düsseldorf (DE)**

(54) **DEVICE FOR MODULATING ELECTROMAGNETIC WAVES AND METHOD FOR PRODUCING THE SAME**

(57)    A device (100), preferably adapted and arranged for modifying at least one property of electromagnetic waves, more preferably adapted and arranged for modulating electromagnetic waves, comprising

a. a waveguide (101) adapted and arranged for the propagation of electromagnetic waves;
b. a first element (102) and a second element (103)
i. wherein, in a cross-sectional cut of the device (100), the first element (102) and the second element (103) are arranged such that
A. a first section (104) of the first element (102) overlaps a first section (105) of the second element (103),
B. a further section (106) of the first element (102) does not overlap the second element (103),
C. the first section (104) of the first element (102) is separated by a first distance (108) from the first section (105) of the second element (103);

ii. wherein the first section (104) of the first element (102) and the first section (105) of the second element (103) are adapted and arranged to be electrically charged and discharged;

c. a further element (109), wherein, in the cross-sectional cut of the device (100), the further element (109) is arranged to overlap the further section (106) of the first element (102);
d. optionally an even-further element (110), wherein, in the cross-sectional cut of the device (100), the even-further element (110) is arranged to overlap a further section (107) of the second element (103).

Fig. 1A

**Description**

## FIELD OF THE INVENTION

The invention pertains to a device for modulating or varying one or more properties of an electromagnetic wave. The invention also pertains to a method for producing the device.

## BACKGROUND

Devices that can modulate, or vary, one or more properties of an electromagnetic wave are important electronic components for optical communication systems, *e.g.*, data transmission via fibre optics. Some of the important parameters for these devices are bandwidth, operation speed, extinction ratio, insertion loss, energy consumption, and footprint. One option is silicon-based modulators. However, silicon modulators have a number of disadvantages. For example, silicon-based modulators have a narrow bandwidth. Furthermore, in order to integrate a silicon-based modulator with other electronic components, such as CMOS integrated circuits, silicon-based modulators have to be produced as part of a front-end-of-line process. In addition, silicon-based modulators cannot easily be integrated with newer technologies that are being developed in the electronic industry. This is in contrast to graphene-based modulators, which have a number of advantages. For example, graphene-based modulators have a broader bandwidth compared to silicon-based modulators. Furthermore, graphene-based modulators can be integrated with other electronic components as part of a back-end-of-line process, without requiring significant development to enable the integration. Graphene-based modulators can also be more easily integrated with newer technologies in the electronic industry. Graphene-based modulators further allow for a better use of surface area, and thus a more compact electronic device or system. Examples of graphene-based modulators are disclosed in, *e.g.,* Liu et al. (2011), A graphene-based broadband optical modulator, Nature, 474, 65, and Liu et al. (2012), Double-layer graphene optical modulator, Nano Letter, 12, 1482.

## OBJECTS

An object of the present invention is to at least partially overcome at least one of the disadvantages encountered in the state of the art.

It is a further object of the invention to provide a device, preferably for modulating an electromagnetic wave, that has a larger bandwidth.

It is a further object of the invention to provide a device, preferably for modulating an electromagnetic wave, that has a smaller insertion loss.

It is a further object of the invention to provide a device, preferably for modulating an electromagnetic wave, that has a reduced energy consumption.

It is a further object of the invention to provide a device, preferably for modulating an electromagnetic wave, that has a larger modulation depth.

It is a further object of the invention to provide a device, preferably for modulating an electromagnetic wave, that allows for a larger bitrate.

It is a further object of the invention to provide a method for producing a device, preferably for modulating an electromagnetic wave.

It is a further object of the invention to provide a method for producing a device, preferably for modulating an electromagnetic wave, wherein the method is easier to perform.

It is a further object of the invention to provide a method for producing a device, preferably for modulating an electromagnetic wave, wherein the method can be more easily adapted for producing different devices, where said devices are preferably used for the modulation of electromagnetic waves.

It is a further object of the invention to provide a method for producing a device, preferably for modulating an electromagnetic wave, wherein the device has improved properties, such as an larger bandwidth, larger bitrate, and a lower energy consumption.

It is a further object of the invention to provide a method for modulating an electromagnetic wave that allows for a larger bandwidth.

It is a further object of the invention to provide a method for modulating an electromagnetic wave that requires less energy.

It is a further object of the invention to provide a method for modulating an electromagnetic wave that allows for a larger bitrate.

**PREFERRED EMBODIMENTS OF THE INVENTION**

A contribution to at least partially fulfilling at least one of the above-mentioned objects is made by any of the embodiments of the invention.

A 1st embodiment of the invention is a device, preferably adapted and arranged for modifying at least one property of electromagnetic waves, more preferably adapted and arranged for modulating electromagnetic waves, comprising

    a. a waveguide adapted and arranged for the propagation of electromagnetic waves;
    b. a first element and a second element

        i. wherein, in a cross-sectional cut of the device, the first element and the second element are arranged such that

            A. a first section of the first element overlaps a first section of the second element,
            B. a further section of the first element does not overlap the second element,
            C. the first section of the first element is separated by a first distance from the first section of the second element;

        ii. wherein the first section of the first element and the first section of the second element are adapted and arranged to be electrically charged and discharged;

    c. a further element, wherein, in the cross-sectional cut of the device, the further element is arranged to overlap the further section of the first element;
    d. optionally an even-further element, wherein, in the cross-sectional cut of the device, the even-further element is arranged to overlap a further section of the second element.

In an aspect of the 1st embodiment, it is preferred that the first section of the first element and the first section of the second element are adapted and arranged to function as a capacitor.

In a preferred embodiment of the device, the first section of the first element and the first section of the second element is adapted and arranged to have an RC time constant that is less than 50 ns, preferably less than 10 ns, more preferably less than 1 ns, and further preferably less than 0.5 ns. This preferred embodiment is a 2nd embodiment of the device, that preferably depends on the 1st embodiment of the invention.

In an aspect of the 2nd embodiment, it is preferred that the RC time constant is at least 0.2 ps, preferably at least 0.5 ps, and more preferably at least 1 ps. In an aspect of the 2nd embodiment, it is preferred that the RC time constant is in the range of 0.2 ps to 50 ns, more preferably in the range of 0.5 ps to 10 ns, and further preferably in the range of 1 ps to 1 ns.

In a preferred embodiment of the device, in the cross-sectional cut of the device, a further section of the second element does not overlap the first element. This preferred embodiment is a 3rd embodiment of the invention, that preferably depends on any of the 1st to 2nd embodiments of the invention.

In a preferred embodiment of the device, the waveguide is adapted and arranged to be in opto-electronic interaction with the first section of the first element, the first section of the second element, or both the first section of the first element and the first section of the second element. This preferred embodiment is a 4th embodiment of the invention, that preferably depends on any of the 1st to 3rd embodiments of the invention.

In a preferred embodiment of the device, at least one or all of the following applies:

    a. the first section of the first element, the further section of the first element, or both, comprise graphene;
    b. the first section of the second element, a further section of the second element, or both, comprise graphene.

This preferred embodiment is a 5th embodiment of the invention, that preferably depends on any of the 1st to 4th embodiments of the invention.

In an aspect of the 5th embodiment, all possible combination of the features a. and b. are preferred aspects of the embodiment. These combinations are *e.g.,* a; b; a+b. In an aspect of the 5th embodiment, it is preferred that both the first section of the first element and the further section of the first element comprise graphene. In an aspect of the 5th embodiment, it is preferred that both the first section of the second element and the further section of the second element comprise graphene. In an aspect of the 5th embodiment, it is preferred that both the first section of the first element and the first section of the second element comprise graphene. In an aspect of the 5th embodiment, it is preferred that both the further section of the first element and the further section of the second element comprise graphene.

In a preferred embodiment of the device, the further element, the even-further element, or both, are adapted and arranged to be electrically charged, electrically discharged, or both. This preferred embodiment is a 6th embodiment of the invention, that preferably depends on any of the 1st to 5th embodiments of the invention. In an aspect of the 6th embodiment, it is preferred that the further element, the even-further element, or both are adapted and arranged to be electrically charged. In an aspect of the 6th embodiment, it is preferred that the further element and the even-further element are adapted and arranged to be electrically charged.

In a preferred embodiment of the device, the further element, the even-further element, or both, have at least one or all of the following properties:

> a. an electrical conductivity of at least $10^4$ S/m, preferably at least $10^5$ S/m, and further preferably at least $10^6$ S/m;
> b. comprise graphene;
> c. are adapted and arranged to have an optical attenuation coefficient in the range of $2 \times 10^{-4}$ to 0.6 dB/$\mu$m, preferably in the range of $2 \times 10^{-2}$ to 0.40 dB/$\mu$m, and more preferably in the range of 0.15 to 0.25 dB/$\mu$m;
> d. are adapted and arranged to have a variable optical attenuation coefficient.

This preferred embodiment is a 7th embodiment of the invention, that preferably depends on any of the 1st to 6th embodiments of the invention.

In an aspect of the 7th embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In an aspect of the 7th embodiment, it is preferred that the aforementioned combinations of features apply to the further element. In an aspect of the 7th embodiment, it is preferred that the aforementioned combinations of features apply to the even-further element. In an aspect of the 7th embodiment, it is preferred that the aforementioned combinations of features apply to both the further element and the even-further element. In an aspect of the 7th embodiment, it is preferred that the further element, the even-further element, or both, are adapted and arranged to have a variable optical attenuation coefficient, wherein said optical attenuation coefficient can be varied to fall within at least one of the ranges of feature c. in the 7th embodiment.

In a preferred embodiment of the device, at least one or all of the following applies:

> a. the first element and the second element are adapted and arranged to produce a first potential difference between the first section of the first element and the first section of the second element;
> b. the first element and the further element are adapted and arranged to produce a second potential difference between the further section of the first element and the further element;
> c. the second element and the even-further element are adapted and arranged to produce a third potential difference between the further section of the second element and the even-further element.

This preferred embodiment is an 8th embodiment of the invention, that preferably depends on any of the 1st to 7th embodiments of the invention.

In an aspect of the 8th embodiment, all possible combination of the features a. to c. are preferred aspects of the embodiment. These combinations are *e.g.,* a; b; c; a+b; a+c; b+c; a+b+c.

In a preferred embodiment of the device, at least one or all of the following applies:

> a. the first potential difference is in the range of -120 V to 120 V, preferably in the range of -100 V to 100 V, more preferably in the range of -50 V to 50 V, even more preferably in the range of - 20 V to 20 V, further preferably in the range of -10 V to 10 V, further preferably in the range of -7 V to 7 V, and even further preferably in the range of -5 V to 5 V;
> b. the second potential difference is in the range of -120 V to 120 V, preferably in the range of -100 V to 100 V, more preferably in the range of -50 V to 50 V, even more preferably in the range of -20 V to 20 V, further preferably in the range of -10 V to 10 V, further preferably in the range of -7 V to 7 V, and even further preferably in the range of -5 V to 5 V;
> c. the third potential difference is in the range of -120 V to 120 V, preferably in the range of -100 V to 100 V, more preferably in the range of -50 V to 50 V, even more preferably in the range of - 20 V to 20 V, further preferably in the range of -10 V to 10 V, further preferably in the range of -7 V to 7 V, and even further preferably in the range of -5 V to 5 V.

This preferred embodiment is a 9th embodiment of the invention, that preferably depends on the 8th embodiment of the invention.

In an aspect of the 9th embodiment, all possible combination of the features a. to c. are preferred aspects of the embodiment. These combinations are *e.g.,* a; b; c; a+b; a+c; b+c; a+b+c.

In a preferred embodiment of the device, at least one or all of the following applies:

a. a quotient of the first potential difference and the first distance is in the range of -12 GV/m to 12 GV/m, preferably in the range of -10 GV/m to 10 GV/m, more preferably in the range of -5 GV/m to 5 GV/m, even more preferably in the range of -2 GV/m to 2 GV/m, further preferably in the range of -1 GV/m to 1 GV/m, and even further preferably in the range of -0.5 GV/m to 0.5 GV/m;

b. a quotient of the second potential difference and a second distance is in the range of -12 GV/m to 12 GV/m, preferably in the range of -10 GV/m to 10 GV/m, more preferably in the range of -5 GV/m to 5 GV/m, even more preferably in the range of -2 GV/m to 2 GV/m, further preferably in the range of -1 GV/m to 1 GV/m, and even further preferably in the range of -0.5 GV/m to 0.5 GV/m;

c. a quotient of the third potential difference and a third distance is in the range of -12 GV/m to 12 GV/m, preferably in the range of -10 GV/m to 10 GV/m, more preferably in the range of -5 GV/m to 5 GV/m, even more preferably in the range of -2 GV/m to 2 GV/m, further preferably in the range of -1 GV/m to 1 GV/m, and even further preferably in the range of -0.5 GV/m to 0.5 GV/m.

This preferred embodiment is a 10th embodiment of the invention, that preferably depends on any of the 8th to 9th embodiments of the invention.

In the 10th embodiment, the second distance is measured between the further element and the further section of the first element. In the 10th embodiment, the third distance is measured between the even-further element and the further section of the second element. In an aspect of the 10th embodiment, all possible combination of the features a. to c. are preferred aspects of the embodiment. These combinations are *e.g.,* a; b; c; a+b; a+c; b+c; a+b+c.

In a preferred embodiment of the device, at least one or all of the following applies:

a. the first element and the second element are adapted and arranged to vary the first potential difference by at least 5 %, preferably at least 30 %, and further preferably at least 100 % over a time interval of 0.05 ps to 70 ns, preferably a time interval of 0.2 ps to 30 ns, and more preferably a time interval of 2 ps to 10 ns;

b. the first element and the further element are adapted and arranged to vary the second potential difference by less than 15 %, preferably less than 10 %, and further preferably less than 5 % over a time interval of at least 100 ps, preferably at least 1 ns, and more preferably at least 1 ms;

c. the second element and the even-further element are adapted and arranged to vary the third potential difference by less than 15 %, preferably less than 10 %, and further preferably less than 5 % over a time interval of at least 100 ps, preferably at least 1 ns, and more preferably at least 1 ms.

This preferred embodiment is an 11th embodiment of the invention, that preferably depends on any of the 8th to 10th embodiments of the invention.

In an aspect of the 11th embodiment, all possible combination of the features a. to c. are preferred aspects of the embodiment. These combinations are *e.g.,* a; b; c; a+b; a+c; b+c; a+b+c.

In a preferred embodiment of the device, in the cross-sectional cut of the device, at least one or all of the following applies:

a. less than 50 %, preferably less than 25 %, more preferably less than 10 %, and further preferably less than 5 % of a surface area of the further element overlaps a surface area of the first section of the first element; in this aspect it is particularly preferred that the further element does not overlap the first section of the first element;

b. less than 50 %, preferably less than 25 %, more preferably less than 10 %, and further preferably less than 5 % of a surface area of the even-further element overlaps a surface area of the first section of the second element; in this aspect it is particularly preferred that the even-further element does not overlap the first section of the second element;

c. less than 50 %, preferably less than 25 %, more preferably less than 10 %, and further preferably less than 5 % of a surface area of the further element overlaps a surface area of the even-further element; in this aspect it is particularly preferred that the further element and the even-further element do not overlap.

This preferred embodiment is a 12th embodiment of the invention, that preferably depends on any of the 1st to 11th embodiments of the invention.

In an aspect of the 12th embodiment, all possible combination of the features a. to c. are preferred aspects of the embodiment. These combinations are *e.g.,* a; b; c; a+b; a+c; b+c; a+b+c.

In a preferred embodiment of the device, at least one or all of the following applies:

a. the further element is arranged such that a first gap is formed between the further element and the second element;

b. the even-further element is arranged such that a further gap is formed between the first element and the even-further element.

This preferred embodiment is a 13th embodiment of the invention, that preferably depends on any of the 1st to 12th embodiments of the invention.

In an aspect of the 13th embodiment, all possible combination of the features a. and b. are preferred aspects of the embodiment. These combinations are *e.g.,* a; b; a+b.

In a preferred embodiment of the device, at least one or all of the following applies:

a. a ratio of a width of the first gap to the first distance is in the range of 0.1 to 100, preferably in the range of 0.5 to 50, and more preferably in the range of 1 to 30;

b. a ratio of a width of the further gap to the first distance is in the range of 0.1 to 100, preferably in the range of 0.5 to 50, and more preferably in the range of 1 to 30.

This preferred embodiment is a 14th embodiment of the invention, that preferably depends on the 13th embodiment of the invention.

In an aspect of the 14th embodiment, all possible combination of the features a. and b. are preferred aspects of the embodiment. These combinations are *e.g.,* a; b; a+b. In an aspect of the 14th embodiment, it is preferred that the ratio of a width of the first gap to the first distance is in the range of 0.8 to 6. In an aspect of the 14th embodiment, it is preferred that the ratio of a width of the further gap to the first distance is in the range of 0.8 to 6.

In a preferred embodiment of the device, at least one or all of the following applies:

a. the width of the first gap is less than or equal to 400 nm, preferably less than or equal to 200 nm, more preferably less than or equal to 150 nm, more preferably less than or equal to 100 nm, more preferably less than or equal to 60 nm, more preferably less than or equal to 30 nm, more preferably less than or equal to 20 nm, further preferably less than or equal to 10 nm, and even further preferably less than or equal to 5 nm.

b. the width of the further gap is less than or equal to 400 nm, preferably less than or equal to 200 nm, more preferably less than or equal to 150 nm, more preferably less than or equal to 100 nm, more preferably less than or equal to 60 nm, more preferably less than or equal to 30 nm, more preferably less than or equal to 20 nm, further preferably less than or equal to 10 nm, and even further preferably less than or equal to 5 nm.

This preferred embodiment is a 15th embodiment of the invention, that preferably depends on any of the 13th to 14th embodiments of the invention.

In an aspect of the 15th embodiment, all possible combination of the features a. and b. are preferred aspects of the embodiment. These combinations are *e.g.,* a; b; a+b. In an aspect of the 15th embodiment, it is preferred that the width of the first gap is in the range of 0.5 nm to 400 nm, preferably in the range of 1 nm to 200 nm, more preferably in the range of 2 nm to 150 nm, further preferably in the range of 5 nm to 100 nm, and even further preferably in the range of 10 nm to 60 nm. In another aspect of the 15th embodiment, it is preferred that the width of the first gap is in the range of 1 nm to 20 nm, more preferably in the range of 5 nm to 10 nm. In an aspect of the 15th embodiment, it is preferred that the width of the further gap is in the range of 0.5 nm to 400 nm, preferably in the range of 1 nm to 200 nm, more preferably in the range of 2 nm to 150 nm, further preferably in the range of 5 nm to 100 nm, and even further preferably in the range of 10 nm to 60 nm. In another aspect of the 15th embodiment, it is preferred that the width of the further gap is in the range of 1 nm to 20 nm, more preferably in the range of 5 nm to 10 nm. In an aspect of the 15th embodiment, it is preferred that the width of the first gap varies by less than 15 %, more preferably by less than 5 % from the width of the further gap.

In a preferred embodiment of the device, at least one or all of the following applies:

a. a ratio of a second distance, measured between the further element and the further section of the first element, to the first distance is in the range of 0.5 to 1.5, preferably in the range of 0.8 to 1.2, more preferably in the range of 0.95 to 1.05, and further preferably in the range from 0.99 to 1.01;

b. a ratio of a third distance, measured between the even-further element and the further section of the second element, to the first distance is in the range of 0.5 to 1.5, preferably in the range of 0.8 to 1.2, and more preferably in the range of 0.95 to 1.05.

This preferred embodiment is a 16th embodiment of the invention, that preferably depends on any of the 1st to 15th embodiments of the invention.

In an aspect of the 16th embodiment, all possible combination of the features a. and b. are preferred aspects of the embodiment. These combinations are *e.g.,* a; b; a+b.

In a preferred embodiment of the device, at least one or all of the following applies:

a. the first distance is in the range of 0.1 to 300 nm, preferably in the range of 1 to 150 nm, more preferably in the range of 5 to 50 nm, even more preferably in the range of 10 nm to 50 nm, and further preferably in the range of 20 nm to 40 nm;

b. a second distance, measured between the further element and the further section of the first element, is in the range of 0.1 to 300 nm, preferably in the range of 1 to 150 nm, more preferably in the range of 5 to 50 nm, even more preferably in the range of 10 nm to 50 nm, and further preferably in the range of 20 nm to 40 nm;

c. a third distance, measured between the even-further element and the further section of the second element, is in the range of 0.1 to 300 nm, preferably in the range of 1 to 150 nm, more preferably in the range of 5 to 50 nm, even more preferably in the range of 10 nm to 50 nm, and further preferably in the range of 20 nm to 40 nm.

This preferred embodiment is a 17th embodiment of the invention, that preferably depends on any of the 1st to 16th embodiments of the invention.

In an aspect of the 17th embodiment, all possible combination of the features a. to c. are preferred aspects of the embodiment. These combinations are *e.g.,* a; b; c; a+b; a+c; b+c; a+b+c.

In a preferred embodiment of the device, at least one or all of the following has in the range of 1 to 10, preferably in the range of 1 to 6, and more preferably in the range of 1 to 3 atomic layers:

a. the first element;
b. the second element.

This preferred embodiment is an 18th embodiment of the invention, that preferably depends on any of the 1st to 17th embodiments of the invention.

In an aspect of the 18th embodiment, all possible combination of the features a. and b. are preferred aspects of the embodiment. These combinations are *e.g.,* a; b; a+b. In an aspect of the 18th embodiment, it is preferred that the first element, the second element, or both, have a single atomic layer, *e.g.,* the first element is a 2D material.

In a preferred embodiment of the device, at least one or all of the following applies to the first section of the first element, the further section of the first element, or both:

a. comprises at least one or all of the following: carbon, a nitride, at least one metal, at least one metal alloy, at least one conductive oxide, at least one conductive polymer, at least one chalcogen, and a combination of at least two or more thereof;
b. has in the range of 1 to 10, preferably in the range of 1 to 6, and more preferably in the range of 1 to 3 atomic layers.

This preferred embodiment is a 19th embodiment of the invention, that preferably depends on any of the 1st to 18th embodiments of the invention.

In an aspect of the 19th embodiment, all possible combination of the features a. and b. are preferred aspects of the embodiment. These combinations are *e.g.,* a; b; a+b. In an aspect of the 19th embodiment, it is preferred that the aforementioned combinations of features apply to the first section of the first element. In an aspect of the 19th embodiment, it is preferred that the aforementioned combinations of features apply to the further section of the first element. In an aspect of the 19th embodiment, it is preferred that the aforementioned combinations of features apply to both the first section and the further section of the first element. In an aspect of the 19th embodiment, aspect a., it is particularly preferred that the first section of the first element, the further section of the first element, or both, comprise carbon, more preferably graphene. In an aspect of the 19th embodiment, aspect b., it is preferred that the first section of the first element, the further section of the first element, or both, have a single atomic layer.

In a preferred embodiment of the device, at least one or all of the following applies to the first section of the second element, the further section of the second element, or both:

a. comprises at least one or all of the following: carbon, a nitride, at least one metal, at least one metal alloy, at least one conductive oxide, at least one conductive polymer, at least one chalcogen, and a combination of at least two or more thereof;
b. has in the range of 1 to 10, preferably in the range of 1 to 6, and more preferably in the range of 1 to 3 atomic layers.

This preferred embodiment is a 20th embodiment of the invention, that preferably depends on any of the 1st to 19th embodiments of the invention.

In an aspect of the 20th embodiment, all possible combination of the features a. and b. are preferred aspects of the embodiment. These combinations are *e.g.,* a; b; a+b. In an aspect of the 20th embodiment, it is preferred that the aforementioned combinations of features apply to the first section of the second element. In an aspect of the 20th embodiment, it is preferred that the aforementioned combinations of features apply to the further section of the second element. In an aspect of the 20th embodiment, it is preferred that the aforementioned combinations of features apply to both the first section and the further section of the second element. In an aspect of the 20th embodiment, aspect a., it is particularly preferred that the first section of the second element, the further section of the second element, or both, comprise carbon, more preferably graphene. In an aspect of the 20th embodiment, aspect b., it is preferred that the first section of the second element, the further section of the second element, or both, have a single atomic layer.

In a preferred embodiment of the device, at least one or all of the following applies to the further element, the even-further element, or both:

a. comprises at least one or all of the following: carbon, a nitride, at least one metal, at least one metal alloy, at least one conductive oxide, at least one conductive polymer, at least one chalcogen, and a combination of at least two or more thereof;
b. has in the range of 1 to 10, preferably in the range of 1 to 6, and more preferably in the range of 1 to 3 atomic layers.

This preferred embodiment is a 21st embodiment of the invention, that preferably depends on any of the 1st to 20th embodiments of the invention.

In an aspect of the 21st embodiment, all possible combination of the features a. and b. are preferred aspects of the embodiment. These combinations are *e.g.,* a; b; a+b. In an aspect of the 21st embodiment, it is preferred that the aforementioned combinations of features apply to the further element. In an aspect of the 21st embodiment, it is preferred that the aforementioned combinations of features apply to the even-further element. In an aspect of the 21st embodiment, it is preferred that the aforementioned combinations of features apply to both the further element and the even-further element. In an aspect of the 21st embodiment, aspect a., it is particularly preferred that the further element, the even-further element, or both, comprise carbon, more preferably graphene. In an aspect of the 21st embodiment, aspect b., it is preferred that the further element, the even-further element, or both, have a single atomic layer.

In a preferred embodiment of the device, the waveguide is adapted and arranged for the propagation of electromagnetic waves that have wavelengths in the range from 300 nm to 3000 nm, preferably in the range of 800 nm to 2100 nm, and more preferably in the range of 1250 nm to 1650 nm. This preferred embodiment is a 22nd embodiment of the invention, that preferably depends on any of the 1st to 21st embodiments of the invention.

In a preferred embodiment of the device, at least one or all of the following applies:

a. a width of the first section of the first element and a width of the first section of the second element are in the range of 10 nm to 2 µm, preferably in the range of 50 nm to 1 µm, more preferably in the range of 60 nm to 500 nm, even more preferably in the range of 70 nm to 400 nm, and further preferably in the range of 80 nm to 200 nm;
b. a length of the first section of the first element and a length of the first section of the second element are in the range of 100 nm to 400 µm, preferably in the range of 500 nm to 250 µm, more preferably in the range of 10 µm to 120 µm, and further preferably in the range of 20 µm to 40 µm;
c. a thickness of the first section of the first element, a thickness of the first section of the second element, or both, are in the range of 0.1 nm to 100 nm, preferably in the range of 0.7 nm to 50 nm, and more preferably in the range of 1.5 nm to 10 nm;
d. a width of the further section of the first element, a width of the further section of the second element, or both, are in the range of 10 nm to 40 µm, preferably in the range of 100 nm to 20 µm, and further preferably in the range of 500 nm to 1 µm;
e. a length of the further section of the first element, a length of the further section of the second element, or both, are in the range of 100 nm to 400 µm, preferably in the range of 500 nm to 250 µm, more preferably in the range of 10 µm to 120 µm, and further preferably in the range of 20 µm to 40 µm;
f. a thickness of the further section of the first element, a thickness of the further section of the second element, or both, are in the range of 0.1 to 100 nm, preferably in the range of 0.7 to 50 nm, and more preferably in the range of 1.5 nm to 10 nm.

This preferred embodiment is a 23rd embodiment of the invention, that preferably depends on any of the 1st to 22nd embodiments of the invention.

In an aspect of the 23rd embodiment, all possible combination of the features a. to f. are preferred aspects of the embodiment. These combinations are *e.g.,* a; b; c; d; e; f; a+b; a+c; a+d; a+e; a+f; b+c; b+d; b+e; b+f; c+d; c+e; c+f; d+e; d+f; e+f; a+b+c; a+b+d; a+b+e; a+b+f; a+c+d; a+c+e; a+c+f; a+d+e; a+d+f; a+e+f; b+c+d; b+c+e; b+c+f; b+d+e; b+d+f; b+e+f; c+d+e; c+d+f; c+e+f; d+e+f; a+b+c+d; a+b+c+e; a+b+c+f; a+b+d+e; a+b+d+f; a+b+e+f; a+c+d+e; a+c+d+f; a+c+e+f; a+d+e+f; b+c+d+e; b+c+d+f; b+c+e+f; b+d+e+f; c+d+e+f; a+b+c+d+e; a+b+c+d+f; a+b+c+e+f; a+b+d+e+f; a+c+d+e+f; b+c+d+e+f; a+b+c+d+e+f.

In a preferred embodiment of the device, at least one or all of the following applies:

a. a width of the further element, a width of the even-further element, or both, are in the range of 10 nm to 40 µm, preferably in the range of 100 nm to 20 $\mu$m, and further preferably in the range of 500 nm to 1 $\mu$m;

b. a length of the further element, a length of the even-further element, or both, are in the range of 100 nm to 400 $\mu$m, preferably in the range of 500 nm to 250 $\mu$m, and more preferably in the range of 10 $\mu$m to 100 $\mu$m;

c. a thickness of the further element, a thickness of the even-further element, or both, are in the range of 0.1 to 100 nm, preferably in the range of 0.7 to 50 nm, and more preferably in the range of 1.5 nm to 10 nm.

This preferred embodiment is a 24th embodiment of the invention, that preferably depends on any of the 1st to 23rd embodiments of the invention.

In an aspect of the 24th embodiment, all possible combination of the features a. to c. are preferred aspects of the embodiment. These combinations are *e.g.,* a; b; c; a+b; a+c; b+c; a+b+c.

In an aspect of the invention, it is preferred that the width of the first section of the first element is in the range of 1 % to 50 %, more preferably in the range of 5 % to 40 %, even more preferably in the range of 10 % to 30 %, and further preferably in the range of 15 % to 25 % of the width of the first element. In an aspect of the invention, it is preferred that the width of the first section of the second element is in the range of 1 % to 50 %, more preferably in the range of 5 % to 40 %, even more preferably in the range of 10 % to 30 %, and further preferably in the range of 15 % to 25 % of the width of the second element.

In a preferred embodiment of the device, at least one or all of the following applies:

a. at least 10 %, preferably at least 35 %, more preferably at least 50 %, and further preferably at least 60 % of a surface area of the further section of the first element overlaps the further element;

b. at least 35 %, preferably at least 50 %, and more preferably at least 60 % of a surface area of the further section of the second element overlaps the even-further element.

This preferred embodiment is a 25th embodiment of the invention, that preferably depends on any of the 1st to 24th embodiments of the invention.

In an aspect of the 25th embodiment, all possible combination of the features a. and b. are preferred aspects of the embodiment. These combinations are *e.g.,* a; b; a+b. In an aspect of the invention, it is preferred that a width of the further element is in the range of 10 % to 150 %, more preferably in the range of 50 % to 130 %, even more preferably in the range of 70 % to 110 %, and further preferably in the range of 90 % to 105 % of the width of the further section of the first element. In an aspect of the invention, it is preferred that a width of the even-further element is in the range of 10 % to 150 %, more preferably in the range of 50 % to 130 %, even more preferably in the range of 70 % to 110 %, and further preferably in the range of 90 % to 105 % of the width of the further section (106) of the second element.

In a preferred embodiment of the device, at least one or all of the following is adapted and arranged as a layer:

a. the first section of the first element;
b. the further section of the first element;
c. the first section of the second element;
d. the further section of the second element;
e. the further element;
f. the even-further element.

This preferred embodiment is a 26th embodiment of the invention, that preferably depends on any of the 1st to 25th embodiments of the invention.

In an aspect of the 26th embodiment, all possible combination of the features a. to f. are preferred aspects of the embodiment. These combinations are *e.g.,* a; b; c; d; e; f; a+b; a+c; a+d; a+e; a+f; b+c; b+d; b+e; b+f; c+d; c+e; c+f; d+e; d+f; e+f; a+b+c; a+b+d; a+b+e; a+b+f; a+c+d; a+c+e; a+c+f; a+d+e; a+d+f; a+e+f; b+c+d; b+c+e; b+c+f; b+d+e; b+d+f; b+e+f; c+d+e; c+d+f; c+e+f; d+e+f; a+b+c+d; a+b+c+e; a+b+c+f; a+b+d+e; a+b+d+f; a+b+e+f; a+c+d+e; a+c+d+f; a+c+e+f; a+d+e+f; b+c+d+e; b+c+d+f; b+c+e+f; b+d+e+f; c+d+e+f; a+b+c+d+e; a+b+c+d+f; a+b+c+e+f; a+b+d+e+f; a+c+d+e+f; b+c+d+e+f; a+b+c+d+e+f.

In a preferred embodiment of the device, at least one or all of the following is arranged less than 1 $\mu$m, preferably less than 500 nm, more preferably less than 150 nm, even more preferably less than 100 nm, further preferably less than 50 nm, and even further preferably less than 30 nm from the waveguide:

a. the first element;
b. the second element;
c. the further element; and
d. the even-further element.

This preferred embodiment is a 27th embodiment of the invention, that preferably depends on any of the 1st to 26th embodiments of the invention.

In an aspect of the 27th embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d.

In a preferred embodiment of the device, the waveguide overlaps at least one or all of the following:

a. the first section of the first element;
b. the first section of the second element.

This preferred embodiment is a 28th embodiment of the invention, that preferably depends on any of the 1st to 27th embodiments of the invention.

In an aspect of the 28th embodiment, all possible combination of the features a. and b. are preferred aspects of the embodiment. These combinations are *e.g.,* a; b; a+b.

In a preferred embodiment of the device, the first element and the second element are separated by a first layer of the first kind. This preferred embodiment is a 29th embodiment of the invention, that preferably depends on any of the 1st to 28th embodiments of the invention.

In a preferred embodiment of the device, the device is an opto-electronic device, preferably selected from the group consisting of a modulator; a detector adapted and arranged for the detection of viruses, antibodies, biomarkers, biomolecules, or a combination of at least two thereof; and a photodetector. This preferred embodiment is a 30th embodiment of the invention, that preferably depends on any of the 1st to 29th embodiments of the invention.

In an aspect of the 30th embodiment, it is particularly preferred that the device is a modulator.

A 31st embodiment of the invention is a method for producing a device, preferably adapted and arranged for modifying at least one property of electromagnetic waves, more preferably adapted and arranged for modulating electromagnetic waves, comprising the steps

a. providing a structure that comprises

i. a first element and a second element,

A. wherein, in a cross-sectional cut of the structure, the first element and the second element are arranged such that

I. a first section of the first element overlaps a first section of the second element,
II. a further section of the first element does not overlap the second element,
III. the first section of the first element is separated by a first distance from the first section of the second element;

B. wherein the first section of the first element and the first section of the second element are adapted and arranged to be electrically charged and discharged;

ii. a further element, wherein, in the cross-sectional cut of the structure, the further element is arranged to overlap the further section of the first element;
iii. optionally an even-further element, wherein, in the cross-sectional cut of the structure, the even-further element is arranged to overlap the further section of the second element.

b. superimposing a waveguide and the structure onto each other.

In a preferred embodiment of the method for producing a device, at least one or all of the following applies:

a. the method further comprises the step of providing the waveguide, prior to the step of providing the structure;
b. the method further comprises the step of providing the waveguide, after the step of providing the structure.

This preferred embodiment is a 32nd embodiment of the invention, that preferably depends on the 31st embodiment of the invention.

In an aspect of the 32nd embodiment, it is preferred that the steps of providing the structure and the superimposing of the waveguide and the structure onto each other are performed as a single step. For example, the waveguide is provided, and the structure is superimposed on the waveguide by producing the structure on the waveguide using, e.g.,

physical vapour deposition. In another aspect of the 32nd embodiment, it is preferred that the steps of providing the waveguide and the superimposing of the waveguide and the structure onto each other are performed as a single step. For example, the structure is provided, and the waveguide is superimposed on the structure by producing the waveguide on the structure using, *e.g.*, physical vapour deposition. In an aspect of the 32nd embodiment, all preferred aspects of the device, according to the 1st to 30th embodiments of the invention, are, *mutatits mutandis,* preferred aspects of the structure. In an aspect of the 32nd embodiment, all possible combination of the features a. and b. are preferred aspects of the embodiment. These combinations are *e.g.,* a; b; a+b.

In a preferred embodiment of the method for producing a device, the step of providing the structure comprises the following sub-steps:

> a. providing a pre-element;
> b. dividing the pre-element into at least two elements.

This preferred embodiment is a 33rd embodiment of the invention, that preferably depends on any of the 31st to 32nd embodiments of the invention.

In an aspect of the 33rd embodiment, it is preferred that the pre-element is a further pre-element that is divided into a second element and a further element. In an aspect of the 33rd embodiment, it is preferred that the pre-element is a first pre-element that is divided into a first element and an even-further element. In an aspect of the 33rd embodiment, it is preferred that at least two pre-elements are provided, a first pre-element and a further pre-element. In this aspect it is preferred that that the first pre-element that is divided into a first element and an even-further element and the further pre-element that is divided into a second element and a further element.

In a preferred embodiment of the method for producing a device, the pre-element is provided using at least one or all of the following:

> a. chemical vapour deposition;
> b. exfoliation;
> c. transferring the pre-element layer from a further substrate;
> d. physical vapour deposition;
> e. spin coating;
> f. molecular epitaxy.

This preferred embodiment is a 34th embodiment of the invention, that preferably depends on the 33rd embodiment of the invention.

In an aspect of the 34th embodiment, all possible combination of the features a. to f. are preferred aspects of the embodiment. These combinations are *e.g.,* a; b; c; d; e; f; a+b; a+c; a+d; a+e; a+f; b+c; b+d; b+e; b+f; c+d; c+e; c+f; d+e; d+f; e+f; a+b+c; a+b+d; a+b+e; a+b+f; a+c+d; a+c+e; a+c+f; a+d+e; a+d+f; a+e+f; b+c+d; b+c+e; b+c+f; b+d+e; b+d+f; b+e+f; c+d+e; c+d+f; c+e+f; d+e+f; a+b+c+d; a+b+c+e; a+b+c+f; a+b+d+e; a+b+d+f; a+b+e+f; a+c+d+e; a+c+d+f; a+c+e+f; a+d+e+f; b+c+d+e; b+c+d+f; b+c+e+f; b+d+e+f; c+d+e+f; a+b+c+d+e; a+b+c+d+f; a+b+c+e+f; a+b+d+e+f; a+c+d+e+f; b+c+d+e+f; a+b+c+d+e+f.

In a preferred embodiment of the method for producing a device, the division of the pre-element into the at least two elements is performed using at least one or all of the following:

> a. laser ablation;
> b. reactive ion etching;
> c. ion milling;
> d. UV activated ozone.

This preferred embodiment is a 35th embodiment of the invention, that preferably depends on any of the 33rd to 34th embodiments of the invention.

In an aspect of the 35th embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d.

In a preferred embodiment of the method for producing a device, prior to the division of the pre-element into the at least two elements, the following sub-steps are performed:

> a. a layer of the further kind is superimposed on the pre-element;
> b. providing at least one recess in the layer of the further kind by removing at least one section of the layer of the further kind, preferably to expose the at least one pre-element.

This preferred embodiment is a 36th embodiment of the invention, that preferably depends on any of the 33rd to 35th embodiments of the invention.

In an aspect of the 36th embodiment, the at least one recess can, for example, be provided using at least one or all of the following: at least one chemical, charged particles (*e.g.*, electrons and ions), photons, atomic force microscopy, oxygen plasma etching, or a combination of at least two thereof. In an aspect of the 36th embodiment, the removal of the at least one section of the layer of the further kind is preferably done using lithography (*e.g.*, deep UV lithography, extreme ultraviolet lithography, electron beam lithography). In an aspect of the 36th embodiment, it is preferred that the division of the pre-element is performed by directing an energy beam through the at least one section. Examples of an energy beam include charged particles (*e.g.*, ions) and photons.

In a preferred embodiment of the method for producing a device, the method further comprises the substep of reducing at least one dimension, preferably a width, of the at least one recess in the layer of the further kind, wherein the at least one dimension is reduced prior to dividing the pre-element into the at least two elements. This preferred embodiment is a 37th embodiment of the invention, that preferably depends on the 36th embodiment of the invention. In the 37th embodiment, examples of the at least one dimension include a width, a length, a height, and a thickness.

In a preferred embodiment of the method for producing a device, the at least one dimension of the at least one section is reduced using atomic layer deposition, *e.g.*, using aluminium oxide. This preferred embodiment is a 38th embodiment of the invention, that preferably depends on the 37th embodiment of the invention.

In an aspect of the invention, it is preferred that the device according to any of the 1st to 30th embodiments of the invention is obtainable from the method according to any of the 31st to 38th embodiments o the invention.

A 39th embodiment of the invention is a device, preferably adapted and arranged for modifying at least one property of electromagnetic waves, more preferably adapted and arranged for modulating electromagnetic waves, obtainable by a method according to the invention, preferably according to any of the 31st to 38th embodiments of the invention.

A 40th embodiment of the invention is a method for producing an electromagnetic wave with at least one modified property, more preferably a modulated electromagnetic wave, comprising the steps of

a. providing a device according to the invention, preferably according to any of the 1st to 30th embodiments of the invention;
b. propagating an electromagnetic wave through the waveguide;
c. applying a first potential difference between the first section of the first element and the first section of the second element;
d. applying a second potential difference between the further section of the first element and the further element;
e. optionally applying a third potential difference between the further section of the further element and the even-further element.

In the 40th embodiment, the electromagnetic wave with at least one modified property should preferably be understood as being modified with respect the state of the electromagnetic wave when said electromagnetic wave is coupled into the waveguide. In an aspect of the 40th embodiment, it is preferred to perform at least two, more preferably all, of the steps b. to e. at least partially simultaneously. In an aspect of the 40th embodiment, it is preferred that the electromagnetic wave is modified to have a change in transmission of at least 1 dB/ns. In an aspect of the 40th embodiment, it is preferred that the electromagnetic wave is modified to have a change in transmission that is equal to or less than 0.01 dB/fs.

In a preferred embodiment of the method for producing an electromagnetic wave with at least one modified property, at least one or all of the following applies:

a. the first potential difference varies by at least 5 %, preferably at least 30 %, and further preferably at least 100 % over a first time interval;
b. the second potential difference varies by less than 15 %, preferably less than 10 %, and further preferably less than 5 % over a second time interval, wherein the first time interval is less than the second time interval;
c. optionally the third potential difference varies by less than 15 %, preferably less than 10 %, and further preferably less than 5 % over a third time interval, wherein the first time interval is less than the third time interval;

This preferred embodiment is a 41st embodiment of the invention, that preferably depends on the 40th embodiments of the invention.

In an aspect of the 41st embodiment, it is preferred that at least one or all of the following partially, more preferably completely, overlaps: the first time interval, the second time interval, and the third time interval. In an aspect of the 41st embodiment, all possible combination of the features a. to c. are preferred aspects of the embodiment. These combinations are *e.g.,* a; b; c; a+b; a+c; b+c; a+b+c.

In a preferred embodiment of the method for producing an electromagnetic wave with at least one modified property, at least one or all of the following applies:

a. the first time interval is in the range of 0.05 ps to 70 ns, preferably a time interval of 0.2 ps to 30 ns, and more preferably a time interval of 2 ps to 10 ns;
b. the second time interval is at least 100 ps, preferably at least 1 ns, and more preferably at least 1 ms;
c. optionally, the third time interval is at least 100 ps, preferably at least 1 ns, and more preferably at least 1 ms.

This preferred embodiment is a 42nd embodiment of the invention, that preferably depends on the 41st embodiment of the invention.
In an aspect of the 42nd embodiment, all possible combination of the features a. to c. are preferred aspects of the embodiment. These combinations are *e.g.,* a; b; c; a+b; a+c; b+c; a+b+c.
In a preferred embodiment of the method for producing an electromagnetic wave with at least one modified property, at least one or all of the following applies:

a. the first potential difference is in the range of -120 V to 120 V, preferably in the range of -100 V to 100 V, more preferably in the range of -50 V to 50 V, even more preferably in the range of - 20 V to 20 V, further preferably in the range of -10 V to 10 V, further preferably in the range of -7 V to 7 V, and even further preferably in the range of -5 V to 5 V;
b. the second potential difference is in the range of -120 V to 120 V, preferably in the range of -100 V to 100 V, more preferably in the range of -50 V to 50 V, even more preferably in the range of -20 V to 20 V, further preferably in the range of -10 V to 10 V, further preferably in the range of -7 V to 7 V, and even further preferably in the range of -5 V to 5 V;
c. optionally, the third potential difference is in the range of -120 V to 120 V, preferably in the range of -100 V to 100 V, more preferably in the range of -50 V to 50 V, even more preferably in the range of -20 V to 20 V, further preferably in the range of -10 V to 10 V, further preferably in the range of -7 V to 7 V, and even further preferably in the range of -5 V to 5 V.

This preferred embodiment is a 43rd embodiment of the invention, that preferably depends on any of the 40th to 42nd embodiments of the invention.
In an aspect of the 43rd embodiment, all possible combination of the features a. to c. are preferred aspects of the embodiment. These combinations are *e.g.,* a; b; c; a+b; a+c; b+c; a+b+c.
In a preferred embodiment of the method for producing an electromagnetic wave with at least one modified property, at least one or all of the following applies:

a. a quotient of the first potential difference and the first distance is in the range of -12 GV/m to 12 GV/m, preferably in the range of -10 GV/m to 10 GV/m, more preferably in the range of -5 GV/m to 5 GV/m, even more preferably in the range of -2 GV/m to 2 GV/m, further preferably in the range of -1 GV/m to 1 GV/m, and even further preferably in the range of -0.5 GV/m to 0.5 GV/m;
b. a quotient of the second potential difference and the second distance is in the range of -12 GV/m to 12 GV/m, preferably in the range of -10 GV/m to 10 GV/m, more preferably in the range of - 5 GV/m to 5 GV/m, even more preferably in the range of -2 GV/m to 2 GV/m, further preferably in the range of -1 GV/m to 1 GV/m, and even further preferably in the range of -0.5 GV/m to 0.5 GV/m;
c. a quotient of the third potential difference and the third distance is in the range of -12 GV/m to 12 GV/m, preferably in the range of -10 GV/m to 10 GV/m, more preferably in the range of -5 GV/m to 5 GV/m, even more preferably in the range of -2 GV/m to 2 GV/m, further preferably in the range of -1 GV/m to 1 GV/m, and even further preferably in the range of -0.5 GV/m to 0.5 GV/m.

This preferred embodiment is a 44th embodiment of the invention, that preferably depends on any of the 40th to 43rd embodiments of the invention.
In an aspect of the 44th embodiment, all possible combination of the features a. to c. are preferred aspects of the embodiment. These combinations are *e.g.,* a; b; c; a+b; a+c; b+c; a+b+c.
A 45th embodiment of the invention is a modified electromagnetic wave obtainable by the method, according to the invention, for producing an electromagnetic wave with at least one modified property, preferably the method according to any of the 40th to 44th embodiments of the invention.
A 46th embodiment of the invention is a use of a potential difference to decrease an optical attenuation coefficient of at least one section of at least one element of a device that is adapted and arranged for modifying at least one property of electromagnetic waves, more preferably adapted and arranged for modulating electromagnetic waves, wherein the potential difference is varied by less than 15 %, preferably less than 10 %, and further preferably less than 5 % over a time interval of at least 100 ps.

In an aspect of the 46th embodiment, it is preferred that the potential difference is varied by less than 15 %, preferably less than 10 %, and further preferably less than 5 % over a time interval of at least 1 ns. In an aspect of the 46th embodiment, it is preferred that the potential difference is varied by less than 15 %, preferably less than 10 %, and further preferably less than 5 % over a time interval of at least 1 ms. In an aspect of the 46th embodiment, it is preferred use the device according to any of the 1st to 30th embodiments of the invention.

A 47th embodiment of the invention is a use of a device adapted and arranged for modifying at least one property of electromagnetic waves, more preferably adapted and arranged for modulating electromagnetic waves, to decrease an optical attenuation coefficient of at least one section of at least one element of the device using a potential difference that is varied by less than 15 %, preferably less than 10 %, and further preferably less than 5 % over a time interval of at least 100 ps.

In an aspect of the 47th embodiment, it is preferred that the potential difference is varied by less than 15 %, preferably less than 10 %, and further preferably less than 5 % over a time interval of at least 1 ns. In an aspect of the 47th embodiment, it is preferred that the potential difference is varied by less than 15 %, preferably less than 10 %, and further preferably less than 5 % over a time interval of at least 1 ms. In an aspect of the 47th embodiment, it is preferred use the device according to any of the 1st to 30th embodiments of the invention.

A 48th embodiment of the invention is a use of a structure for producing an opto-electronic device, wherein the structure comprises

    a. a first element and a second element

        i. wherein, in a cross-sectional cut of the structure, the first element and the second element are arranged such that

            A. a first section of the first element overlaps a first section of the second element,
            B. a further section of the first element does not overlap the second element,
            C. the first section of the first element is separated by a first distance from the first section of the second element;

        ii. wherein the first section of the first element and the first section of the second element are adapted and arranged to be electrically charged and discharged;

    b. a further element, wherein, in the cross-sectional cut of the structure, the further element is arranged to overlap the further section of the first element;
    c. optionally an even-further element, wherein, in the cross-sectional cut of the structure, the even-further element is arranged to overlap a further section of the second element.

In an aspect of the 48th embodiment, it is preferred that any of the 2nd to 30th preferred embodiments of the invention apply, mutatis mutandis, to the 48th embodiment.

## DETAILED DESCRIPTION OF THE INVENTION

Throughout this document, disclosures of ranges should preferably be understood to include both end points of the range. Furthermore, each disclosure of a range in the document should preferably be understood as also disclosing preferred sub-ranges in which one end point is excluded or both end points are excluded. For example, a disclosure of a range from 200 nm to 800 nm is to be understood as disclosing a range that includes both of the end points 200 nm and 800 nm. Furthermore, it is to be understood as also disclosing a range that includes the end point 200 nm but excludes the end point 800 nm, a range that excludes the end point 200 nm but includes the end point 800 nm, and a range that excludes both end points 200 nm and 800 nm.

Some preferred embodiments and preferred aspects may comprise different combinations of features. If the various combinations are listed, the combinations are separated by a semi-colon (";"). For example, the list "a; a+b; a+c+d" should be understood to disclose an embodiment and/or an aspect that comprises the feature "a", an embodiment and/or an aspect that comprises the features "a" and "b", and an embodiment and/or an aspect that comprises the features "a", "c", and "d".

When reference is made to "components", this should preferably be understood as the components of which the device, according to the invention, is comprised of. Examples of a component include the following: the first element, the second element, the further element, an even-further element, the waveguide, a first electrical contact, a second electrical contact, a third electrical contact, a fourth electrical contact, the first section of the first element, the further section of the first element, the first section of the second element, and the further section of the second element.

Waveguide

Waveguides suitable for the invention include, but are not limited to, strip waveguides, rib waveguides, slot waveguides, buried waveguides, and diffused waveguides.

A preferred waveguide comprises at least one or all of the following: silicon, oxygen, aluminium, iridium, tantalum, titanium, nitrogen, lithium, niobium, indium, phosphorus, gallium, arsenic, barium, a chalcogenide, at least one polymer, a resin, and a combination of at least two thereof. Examples of combinations of the aforementioned materials include titanium dioxide, aluminium nitride, tantalum pentoxide, silicon nitride, aluminium oxide, silicon oxynitride, lithium niobate, silica, indium phosphide, gallium arsenide, indium gallium arsenide, barium titanate, and aluminium gallium arsenide. A preferred chalcogenide is a dichalcogenide, more preferably a transition metal dichalcogenide.

A preferred waveguide is adapted and arranged for the propagation of electromagnetic waves that have wavelengths in at least one or all of the following ranges: 1260 nm to 1360 nm (also known as the Original Band or O-Band), 1360 nm to1460 nm (also known as the Extend Band or E-Band), 1460 nm to1530 nm (also known as the Short Band or S-Band), 1530 nm to 1565 nm (also known as the Conventional Band or C-Band), and 1565 nm to 1625 nm (also known as the Long Band or L-Band). In an aspect of the invention, it is particularly preferred that the waveguide is adapted and arranged for the propagation of electromagnetic waves that have wavelengths in the O-band, the C-band, or both.

Where it is disclosed that the waveguide is adapted and arranged for the propagation of electromagnetic waves that have wavelengths in a given wavelength range, this should not be understood to mean that the waveguide is necessarily only adapted for the propagation of electromagnetic waves in that given wavelength range. Rather, it should preferably be understood to mean that the waveguide is at least adapted and arranged for the propagation of electromagnetic waves in the given wavelength range.

In an aspect of the invention, it is preferred that the waveguide has a core layer and a cladding layer that at least partially surrounds the core layer.

In an aspect of the invention, it is preferred that one or more, more preferably all, elements (*e.g.*, the first element, the second element, the further element, the even-further element) are arranged below the waveguide, when viewed in a cross-sectional cut of the device. In another aspect of the invention, it is preferred that one or more, more preferably all, elements (*e.g.*, the first element, the second element, the further element, the even-further element) are arranged above the waveguide, when viewed in a cross-sectional cut of the device. In yet another aspect of the invention, it is preferred that one or more elements (*e.g.*, the first element, the second element) are arranged to pass through the waveguide, when viewed in a cross-sectional cut of the device.

Element

Examples of an element are the first element, the second element, the further element, and the even-further element. The adjectives "first", "second", "further", and "even-further" should not be understood as limiting the order that the elements are arranged in, *e.g.,* in a cross-sectional cut of the device. For example, the second element may be arranged above the first element in a cross-sectional cut of the device.

An element preferably has an electrical conductivity, at 20 °C, of at least $10^4$ S/m, more preferably at least $10^5$ S/m, even more preferably at least $10^6$ S/m, and further preferably at least $10^7$ S/m. The values for the electrical conductivity are preferably for an element that has a thickness of 0.35 nm.

In an aspect of the invention, it is preferred that the first element and the second element are not in electrical connection. In an aspect of the invention, it is preferred that the further element and the even-further element are not in electrical connection. In an aspect of the invention, it is preferred that the further element and the first element are not in electrical connection. In an aspect of the invention, it is preferred that the further element and the second element are not in electrical connection. In an aspect of the invention, it is preferred that the even-further element and the first element are not in electrical connection. In an aspect of the invention, it is preferred that the even-further element and the second element are not in electrical connection.

In an aspect of the invention, it is preferred that the first element is arranged in the form of a layer. In another aspect of the invention, it is preferred that the second element is arranged in the form of a layer. In an aspect of the invention, it is preferred that the further element is arranged in the form of a layer. In another aspect of the invention, it is preferred that the even-further element is arranged in the form of a layer.

In one aspect of the invention, it is preferred that at least two of the following matches by at least 90 wt-%, more preferably by at least 95 wt-% in their composition: the first element, the second element, the further element, and the even-further element. For example, the first element and the second element are made from the same material and/or have the same composition, such as graphene. For example, the first element, the second element, the further element, and the even-further element are made from the same material and/or have the same composition, such as graphene. In yet another aspect of the invention, it is preferred that at least two, preferably all, of the following comprise graphene: the first element, the second element, the further element, and the even-further element.

At least two elements (*e.g.*, one element and another element) that matches by at least *X* wt-% in their composition should preferably be understood as follows: one element has a composition Y, and the another element comprises at least X wt-% of Y, based on a weight of the another element. Examples of the composition Y include a single chemical element (*e.g.*, carbon), a composition of chemical elements (*e.g.*, boron nitride), and a mixture of chemical elements (*e.g.*, a mixture of carbon and aluminium).

In another aspect of the invention, it is preferred that at least two of the following matches by less than 90 wt-%, more preferably by less than 70 wt-% in their composition: the first element, the second element, the further element, and the even-further element. For example, the first element is made from graphene, while the second element comprises a metal. For example, the first element is made from graphene, the second element comprises a metal, the further element comprises a conductive polymer, and the even-further element comprises a conductive oxide.

At least two elements (*e.g.*, one element and another element) that matches by less than *X* wt-% in their composition should preferably be understood as follows: one element has a composition Y, and the another element comprises less than Xwt-% of Y, based on a weight of the another element. Examples of the composition Y include a single chemical element (*e.g.*, carbon), a composition of chemical elements (*e.g.*, boron nitride), and a mixture of chemical elements (*e.g.*, a mixture of carbon and aluminium).

In an aspect of the invention, it is preferred that at least one, more preferably all, of the following is arranged substantially parallel: the first element, the second element, the further element, and the even-further element.

In an aspect of the invention, it is preferred that at least one or all of the following is at least partially surrounded by a layer of an even-further kind: the first element, the second element, the further element, and the even-further element.

In an aspect of the invention, it is preferred that, in a cross-sectional cut of the device, at least one or all of the following is arranged on only one side of the waveguide: the first element, the second element, the further element, and the even-further element.

Cross-sectional cut

A cross-sectional cut of the device should preferably be understood as a cut that is made perpendicular to the direction of propagation of the electromagnetic waves through the waveguide.

Overlap

At least two components (*e.g.*, the first element and the second element, the further element and the first element, an even-further element and the second element, the waveguide and the first sections of the first element and the second element) that overlap should preferably be understood to mean that at least one component at least partially covers at least one other component when a cross-sectional cut of the device is viewed. At least two components that overlap should not be understood to necessarily imply that at least one component completely covers at least one other component. If at least two components overlap, one component may completely cover another component, or the one component may only partially cover the other component. For example, the first element and the second element overlap such that only the first sections of the first element and the second element cover each other. For example, the first element completely covers the further element.

When one component overlaps another component, this should preferably be understood to include the following arrangement: the one component overlaps the another component; the one component is being overlapped by the another component.

At least two component that overlap should preferably be understood to include the following arrangements of the at least two components: the at least two components are arranged substantially parallel to each other; the at least two components are arranged such that an angle between any two components, of the at least two components, is less than 90°.

At least two components that overlap should not be understood to necessarily imply that the at least two components touch each other. At least two components that overlap may touch each other, but this is not a requirement.

A waveguide and a component (*e.g.*, the first element, the second element, the further element, an even-further element, first section of an element, a further section of an element) that overlap should preferably be understood to include an arrangement of the component and the waveguide such that the component passes through the waveguide.

Sections of the elements

Sections of the first element and the second element that overlap are defined as first sections. This should preferably be understood to mean that the presence of a first section in a first element implies the presence of a first section in a second element. For example, a first section of a first element overlaps a first section of the second element.

A section of the first element that does not overlap the second element is defined as a further section. Similarly, a section of the second element that does not overlap the first element is defined as a further section. This should not be understood to mean that the presence of a further section of the first element necessarily implies the presence of a further section of the second element. For example, the first element and the second element overlap, with only the first element having a further section. However, it is preferred that both the first element and the second element have a further section.

In an aspect of the invention, it is preferred that a first section and a further section of an element (the first element, the further element) matches by less than 90 wt-%, more preferably by less than 70 wt-% in their composition. For example, the first section may comprise graphene and no conductive polymer, while the further section comprises a conductive polymer but not graphene. In another, more preferred aspect of the invention, the first section and the further section of an element (the first element, the further element) matches by at least 90 wt-%, more preferably by at least 95 wt-% in their composition.

When a first section and a further section of an element matches by at least $X$ wt-% in their composition, this should preferably be understood as follows: one section has a composition Y, and the another section comprises at least X wt-% of Y, based on a weight of the another section. When a first section and a further section of an element matches by less than $X$ wt-% in their composition, this should preferably be understood as follows: one section has a composition Y, and the another section comprises less than $X$ wt -% of Y, based on a weight of the another section. Examples of the composition Y include a single chemical element (*e.g.*, carbon), a composition of chemical elements (*e.g.,* boron nitride), and a mixture of chemical elements (*e.g.,* a mixture of carbon and aluminium).

In an aspect of the invention, it is preferred that the first section and the further section of an element (the first element, the further element) are in electrical connection. In another aspect of the invention, it is preferred that the first section and the further section of an element (the first element, the further element) are continuous, *e.g.*, the element is in the form of a layer.

### Capacitor

A capacitor should preferably be understood as at least two surfaces that are adapted and arranged to store electrical energy in an electric field, *e.g.*, by accumulating electric charges on the at least two surfaces. The at least two surfaces of a preferred capacitor are preferably not in physical contact. The at least two surfaces of a preferred capacitor are preferably not in electrical contact. Preferably a capacitor, more preferably the at least two surfaces, are adapted and arranged to be charged and discharged, and further preferably have an RC time constant that is less than 50 ns. An example of the at least two surfaces is the first sections of the first element and the second element.

### Electrical contacts

In an aspect of the invention, it is preferred that the device comprises a first electrical contact that is in electrical connection with the first element. In another aspect of the invention, it is preferred that the device comprises a second electrical contact that is in electrical connection with the second element. In yet another aspect of the invention, it is preferred that the device comprises a third electrical contact that is in electrical connection with the further element. In a further aspect of the invention, it is preferred that the device comprises a fourth electrical contact that is in electrical connection with the even-further element.

### Electrical connection

At least two components that are in electrical connection should preferably be understood to mean that an electrical current can flow between the at least two components. At least two components that are in electrical connection should preferably be understood to mean that a maximum resistance between the at least two components is 100 MQ. Example of at least two components that are in electrical connection include a first section and a further section; an electrical contact and a corresponding element; and an electrical contact and a component.

### Opto-electronic interaction

A waveguide that is adapted and arranged for opto-electronic interaction with a component should preferably be understood to mean that electromagnetic waves that propagate in the waveguide can interact with the component. Examples of the component include an element, preferably a first section of an element. A preferred opto-electronic interaction modifies at least one property of the electromagnetic waves that propagate in the waveguide

An opto-electronic device should preferably be understood as a device that controls and/or detects electromagnetic waves. An example of controlling electromagnetic waves is the modulation of electromagnetic waves.

Modification

Modification of an electromagnetic wave should preferably be understood as the modification of one or more properties of an electromagnetic wave. Examples of the properties include amplitude, phase, frequency, and polarisation. In an aspect of the invention, it is preferred that an amplitude is modified. Examples of modifying at least one property of an electromagnetic wave is a modulation of the electromagnetic wave, an at least partial absorption of the electromagnetic wave, or both.

In an aspect of the invention, it is preferred that the at least one property of an electromagnetic wave is modified by modulation, preferably for the transmission of information, more preferably by imposing a signal on the electromagnetic wave. In this aspect, it is preferred that an amplitude is modulated.

Layers

A component in the form of a layer should preferably be understood as a component (*e.g.*, an element) that has a thickness that is less than 50 % of a width, a length, or both, of the component.

A layer of the first kind is preferably a layer that the skilled person would consider as a dielectric layer. A layer of the first kind preferably has a dielectric constant of 5 or more. A layer of the first kind preferably has an electrical conductivity that is less than $10^{-5}$ S/m. A layer of the first kind preferably comprises at least one oxide, at least one nitride, or a combination thereof. Examples of an oxide include silicon dioxide, aluminium oxide, zirconium dioxide, hafnium oxide, titanium dioxide, niobium pentoxide, tantalum pentoxide. An example of a nitride is silicon nitride, aluminium nitride, and silicon oxynitride.

At least one or all of the following preferably has a dielectric constant of 5 or more: the first layer of the first kind, the further layer of the first kind, and the even-further layer of the first kind. Examples of materials with a dielectric constant of 5 or more include aluminium oxide, zirconium dioxide, hafnium oxide, titanium dioxide, niobium pentoxide, tantalum pentoxide. An example of a nitride is silicon nitride.

A layer of the further kind is preferably any layer of material that the skilled person would consider suitable to at least partially protect layers and/or components (*e.g.*, an element) and/or portions of layers and/or components (*e.g.*, an element) below the layer of the further kind when producing the device. It is preferred that the layers and/or components and/or portions of layers and/or components (*e.g.*, an element) are at least partially protected from an energy beam (*e.g.*, charged particles, photons) by the layer of the further kind. A layer of the further kind is preferably a photoresist, more preferably a positive photoresist. Photoresists are well-known to the skilled person working in the field of manufacturing electronic devices. An example of a suitable photoresist is AZ® MIR 701 which is commercially available from MicroChemicals GmbH (Germany).

A preferred layer of an even-further kind preferably comprises a nitride, an oxide, or a combination thereof. A preferred nitride for the layer of the even-further kind is boron nitride, and more preferably hexagonal boron nitride. A preferred oxide for the layer of the even-further kind is graphene oxide. A layer of the even-further kind preferably has a resistivity that is at least 100 times, more preferably at least 1000 times, and further preferably at least 10000 times larger than a resistivity of an element.

Electrically charged

A component (*e.g.*, the first element, the second element the further element, the even-further element) that is adapted and arranged to be electrically charged should preferably be understood to mean that the component is adapted an arranged to store a net electrical charge, preferably on a surface of the component. The storing of a net electrical charge preferably produces an electric field around the component. In a preferred aspect of the invention, at least one component that is adapted and arranged to be electrically charged is adapted and arranged to store a net electrostatic charge. It is particularly preferred that this aspect, regarding electrostatic charge, applies to the further element, the even-further element, or both.

A component that is adapted and arranged to be electrically charged can, for example, be charged by at least one or all of the following: connecting the component to an electric circuit (*e.g.*, connecting the component to an electrical contact), the component has an intrinsic net electrical charge (*e.g.*, without requiring connection to a circuit), the component can be charged by irradiating the component with photons.

A component (*e.g.*, the first element, the second element the further element, the even-further element) that is adapted and arranged to be electrically discharged should preferably be understood to mean that at least a fraction of any net charge stored in the element can be removed, thereby reducing the net electrical charge.

Optical attenuation coefficient

The optical attenuation coefficient should preferably be understood to be a measure that describes the extent to which a radiant flux of a beam of electromagnetic waves is reduced per unit length when it passes through a specific material.

Variable optical attenuation coefficient

An element that is adapted and arranged to have a variable optical attenuation coefficient should preferably be understood to mean that an optical attenuation coefficient of the element can be modified, preferably when the element is placed in an external electrical field and/or an electric field is present between the element and at least one other component (*e.g.*, another element). For example, the optical attenuation coefficient of an element can be increased or decreased when a first element and a second element are electrically charged such that an electric field is present between the first element and the second element. In an aspect of the invention, it is preferred that the optical attenuation coefficient can be reduced, preferably by at least 20 %, more preferably by at least 50 %, and further preferably by at least 85 %.

In an aspect of the invention, if an element is adapted and arranged to have a variable optical attenuation coefficient, it is preferred that the optical attenuation coefficient is modifiable for multiple wavelengths of electromagnetic waves, preferably for electromagnetic waves that have wavelengths in the range of 1200 nm to 1700 nm.

Composition of elements

Examples of transitional metals are molybdenum and tungsten. A chalcogen is defined as a chemical element in Group 16 of the periodic table (*e.g.*, S, Se, and Te). An example of a combination of at least one transitional metal and at least one chalcogen is a transition metal dichalcogenide (*e.g.*, $MoS_2$, $WS_2$, $MoSe_2$, $WSe_2$, $MoTe_2$).

A conductive polymer should preferably be understood as an organic polymer that is adapted and arranged to conduct electricity. A preferred conductive polymer has an electrical conductivity of at least $10^4$ S/m, more preferably of at least $10^5$ S/m, even more preferably of at least $10^6$ S/m.

A conductive oxide should preferably be understood as an oxide that is adapted and arranged to conduct electricity. A preferred conductive oxide has an electrical conductivity of at least $10^4$ S/m, more preferably of at least $10^5$ S/m, even more preferably of at least $10^6$ S/m.

In an aspect of the invention, a preferred form of carbon is graphene. In an aspect of the invention, a preferred metal is a transitional metal. In an aspect of the invention, a preferred nitride is boron nitride, more preferably hexagonal boron nitride.

A 2D material should preferably be understood as a solid, preferably a crystalline solid. In one aspect of the invention, it is preferred that a 2D material consists of a single layer of atoms. In another aspect of the invention, it is preferred that the 2D material comprises more than one layer of atoms (*e.g.*, more than one individual atomic plane), where these layers are bonded to each other by van der Waals forces.

Gap between element and component

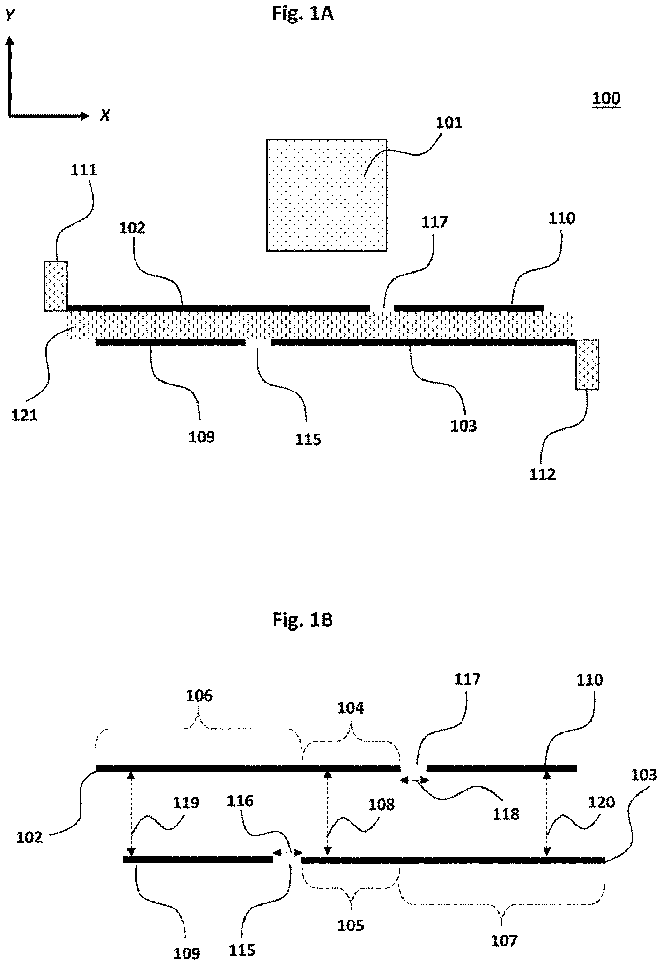

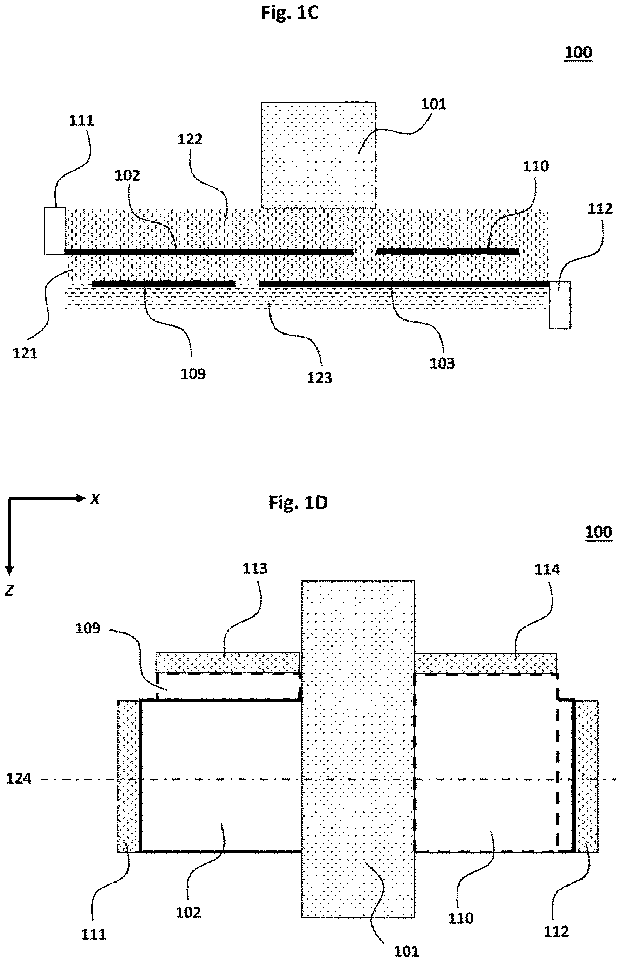

A gap between two elements (the first element and the even-further element, the second element and the further element) should preferably be understood that the two elements are offset from each other in a horizontal direction, where the horizontal direction corresponds to the x-axis as shown in Figs 1A and 1D. A width of a gap is preferably measured along the x-axis as shown in Figs 1A and 1D.

Variation of potential differences

In an aspect of the invention, it is preferred that the first element and the second element are adapted and arranged to produce a first potential difference between the first section of the first element and the first section of the second element. In this aspect, it is preferred that the first element and the second element are adapted and arranged to vary the first potential difference by at least 5 % over a time interval of 0.05 ps to 70 ns, preferably a time interval of 0.2 ps to 30 ns, and more preferably a time interval of 2 ps to 10 ns. In this aspect, it is preferred that the first element and the second element are adapted and arranged to vary the first potential difference by at least 30 % over a time interval of 0.05 ps to 70 ns, preferably a time interval of 0.2 ps to 30 ns, and more preferably a time interval of 2 ps to 10 ns. In this aspect, it is preferred that the first element and the second element are adapted and arranged to vary the first potential difference by at least 100 % over a time interval of 0.05 ps to 70 ns, preferably a time interval of 0.2 ps to 30 ns, and more preferably a time interval of 2 ps to 10 ns.

In an aspect of the invention, it is preferred that the first element and the further element are adapted and arranged to produce a second potential difference between the further section of the first element and the further element. In this aspect, it is preferred that the first element and the further element are adapted and arranged to vary the second potential difference by less than 15 % over a time interval of at least 100 ps, preferably at least 1 ns, and more preferably at least 1 ms. In this aspect, it is preferred that the first element and the further element are adapted and arranged to vary the second potential difference by less than 10 % over a time interval of at least 100 ps, preferably at least 1 ns, and more preferably at least 1 ms. In this aspect, it is preferred that the first element and the further element are adapted and arranged to vary the second potential difference by less than 5 % over a time interval of at least 100 ps, preferably at least 1 ns, and more preferably at least 1 ms.

In an aspect of the invention, it is preferred that the second element and the even-further element are adapted and arranged to produce a third potential difference between the further section of the second element and the even-further element. In this aspect, it is preferred that the second element and the even-further element are adapted and arranged to vary the third potential difference by less than 15 % over a time interval of at least 100 ps, preferably at least 1 ns, and more preferably at least 1 ms. In this aspect, it is preferred that the second element and the even-further element are adapted and arranged to vary the third potential difference by less than 10 % over a time interval of at least 100 ps, preferably at least 1 ns, and more preferably at least 1 ms. In this aspect, it is preferred that the second element and the even-further element are adapted and arranged to vary the third potential difference by less than 5 % over a time interval of at least 100 ps, preferably at least 1 ns, and more preferably at least 1 ms.

In an aspect of the invention, it is preferred that the first element and the second element are adapted and arranged to vary the first potential difference by at least 0.2 V, more preferably at least 0.7 V, and further preferably at least 1.6 V over a time interval of 0.05 ps to 70 ns, preferably a time interval of 0.2 ps to 30 ns, and more preferably a time interval of 2 ps to 10 ns. In another aspect of the invention, it is preferred that the first element and the second element are adapted and arranged to vary the first potential difference by a value that is in the range of 0.2 V to 5 V, more preferably in the range of 0.6 V to 3 V, and further preferably in the range of 0.8 V to 2 V, over a time interval of 0.05 ps to 70 ns, preferably a time interval of 0.2 ps to 30 ns, and more preferably a time interval of 2 ps to 10 ns.

In an aspect of the invention, it is preferred that the first element and the further element are adapted and arranged to vary the second potential difference by less than 0.5 V, more preferably less than 0.1 V, and further preferably less than 0.05 V over a time interval of at least 100 ps, preferably at least 1 ns, and more preferably at least 1 ms.

In an aspect of the invention, it is preferred that the second element and the even-further element are adapted and arranged to vary the third potential difference by less than 0.5 V, more preferably less than 0.1 V, and further preferably less than 0.05 V over a time interval of at least 100 ps, preferably at least 1 ns, and more preferably at least 1 ms.

In an aspect of the method for producing an electromagnetic wave with at least one modified property, it is preferred that the first potential difference varies by at least 0.2 V, more preferably at least 0.7 V, and further preferably at least 1.6 V over a time interval of 0.05 ps to 70 ns, preferably a time interval of 0.2 ps to 30 ns, and more preferably a time interval of 2 ps to 10 ns. In another aspect of the method for producing an electromagnetic wave with at least one modified property, it is preferred that the first potential difference varies by a value that is in the range of 0.2 V to 5 V, more preferably in the range of 0.6 V to 3 V, and further preferably in the range of 0.8 V to 2 V, over a time interval of 0.05 ps to 70 ns, preferably a time interval of 0.2 ps to 30 ns, and more preferably a time interval of 2 ps to 10 ns.

In an aspect of the method for producing an electromagnetic wave with at least one modified property, it is preferred that the second potential difference varies by less than 0.5 V, more preferably less than 0.1 V, and further preferably less than 0.05 V over a time interval of at least 100 ps, preferably at least 1 ns, and more preferably at least 1 ms.

In an aspect of the method for producing an electromagnetic wave with at least one modified property, it is preferred that the third potential difference varies by less than 0.5 V, more preferably less than 0.1 V, and further preferably less than 0.05 V over a time interval of at least 100 ps, preferably at least 1 ns, and more preferably at least 1 ms.

Distances

The first distance should preferably be understood as the shortest distance measured between the first section of the first element and the first section of the second element, when viewed in a cross-sectional cut of the device. The first distance is preferably measured along the *y*-axis, as shown in Fig. 1A.

A second distance should preferably be understood as the shortest distance measured between the further element and the further section of the first element, when viewed in a cross-sectional cut of the device. The second distance is preferably measured along the *y*-axis, as shown in Fig. 1A.

A third distance should preferably be understood as the shortest distance measured between the even-further element and the further section of the second element, when viewed in a cross-sectional cut of the device. The third distance is preferably measured along the *y*-axis, as shown in Fig. 1A.

Where it is disclosed that a component (*e.g.*, an element, a component) is arranged less than $\delta$ $\mu$m from the waveguide, this should preferably be understood to mean that a distance between the component and the waveguide

is less than $\delta$ μm. A distance between a component (*e.g.*, an element, a component) and the waveguide is preferably understood as the shortest distance measured between the component and the waveguide, when viewed in a cross-sectional cut of the device. This distance is preferably measured along the *y*-axis, as shown in Fig. 1A. If a component (*e.g.*, an element) is arranged to pass through the waveguide, the distance between the component and the waveguide is 0 μm.

## Dimensions of the device

Where values for dimensions are disclosed, these dimensions are preferably measured as follows: widths are preferably measured along the x-axis, heights and thicknesses are preferably measured along the *y*-axis, and lengths are preferably measured along the z-axis, as shown in Figs 1A and 1D.

## Superimposed

When one component is superimposed on another component, this should not be understood as requiring that the two components should touch each other. For example, a waveguide layer that is superimposed on an element includes, *e.g.,* the following: the waveguide layer and the element touch each other; a layer of the first kind is arranged between the waveguide layer and the element.

## Graphene

Graphene suitable for the present invention is commercially available from, *e.g.*, Graphenea S.A. (Spain), Graphene Laboratories Inc. (USA), and Grolltex Inc (USA).

## Biomolecules and biomarkers

Example of biomolecules include DNA, amino acids, fat, constituents of animal or human cells, and proteins. A biomarker should preferably be understood as a marker for biomolecules, wherein the biomarker is adapted and arranged to attach to biomolecules, preferably to make the biomolecules detectable (*e.g.*, by fluorescence).

## Layer deposition

In an aspect of the method for producing a device, according to the invention, a layer of the first kind is preferably superimposed using atomic layer deposition, chemical vapour deposition, physical vapour deposition, surface activation by plasma, sacrificial layers or molecular monolayers, or a combination of at least two thereof.
In an aspect of the method for producing a device, according to the invention, a waveguide is preferably superimposed using atomic layer deposition, chemical vapour deposition, physical vapour deposition, lithography, or a combination of at least two thereof.
Examples of lithography include nanoimprint lithography, laser lithography, electron beam lithography, and optical lithography.
Atomic layer deposition, chemical vapour deposition, physical vapour deposition, and lithography are well-known to the skilled person. Any device which the skilled person deems suitable can be used for the layer deposition

## TEST METHODS

The test methods which follow were utilized within the context of the invention. Unless stated otherwise, the measurements were conducted at an ambient temperature of 23 °C, an ambient air pressure of 100 kPa (0.986 atm) and a relative air humidity of 50 %.

## RC time constant

The RC time constant between the first section of the first element and the first section of the second element is measured using a Vector Network Analyzer (VNA) connected to the device (according to the invention) using shielded cable transmission lines. The connection to the device is made using an RF semiconductor Probe Tip (the Infinity Probe commercially available from FormFactor Inc. (USA)). The measurement setup is calibrated to isolate the RC behaviour of the device in order to suppress the influence of the interconnection on the measurements. The VNA is calibrated using the multireflect-thru method described in Lewandowski and Gu (2017), *A Multireflect-Thru Method of Vector Network Analyzer Calibration,* IEEE Transactions on Microwave Theory and Techniques, **65**, 3, 905.

Potential difference

The potential difference between two elements is determined using a voltmeter. The measurement is made at the respective electrical contacts of the two elements.

Size of components of the device

The length and width of the components, such as the element, of the device are determined using scanning electron microscopy (SEM). The thickness of the components, such as the elements, of the device are measured using transmission electron microscopy (TEM). If an element is made up of a number of layers, the number of layers can also be determined using TEM (e.g., an element is made up of a number of layers of graphene). The TEM device is calibrated according to ISO 29301:2017.

Composition of element and component

If an element comprises graphene, the presence of graphene can be determined using Raman spectroscopy. Apart from graphene, the composition of an element can be determined using X-ray photoelectron spectroscopy.

Ratio of dimensions

A ratio of a first dimension A to a second dimension B is determined as follows:

$$\text{ratio} = A/B.$$

An example of a ratio of dimensions is the ratio of the width of the first gap to the first distance.

Variation in potential difference

The % variation ($\Delta\%$) of potential difference $V$ over a time interval $T$ is determined as follows:

$$\Delta\% = (V_{max} - V_{min}) / V_{avg},$$

where $V_{max}$ is the maximum potential difference measured in the time interval $T$, $V_{min}$ is the minimum potential difference measured in the time interval $T$, and $V_{avg}$ is the average potential difference measured over the time interval $T$.

The invention is now illustrated by non-limiting examples and exemplifying embodiments.

**FIGURES**

List of figures

The figures serve to exemplify the present invention, and should not be viewed as limiting the invention. Furthermore, the figures are not drawn to scale.

Fig. 1A:  cross-sectional cut of a device according to the invention.
Fig. 1B:  simplified cross-sectional cut of a device according to the invention.
Fig. 1C:  cross-sectional cut of a device according to the invention with further details.
Fig. 1D:  top view of a device according to the invention.
Fig. 2:  cross-sectional cut of a structure according to the invention.
Fig. 3:  flow diagram illustrating the steps of a first method for producing a device according to the invention.
Fig. 4:  schematic illustration of a method for producing a device.
Fig. 5:  flow diagram illustrating the steps of a second method for producing a device according to the invention.
Fig. 6:  flow diagram illustrating the steps of a method for producing an electromagnetic wave with at least one modified property.
Fig. 7:  examples of alternative arrangements of the waveguide and the elements of the device according to the invention.

Description of figures

Fig. 1A shows a cross-sectional cut of a device (100) according to the invention. Fig. 1B shows a simplified version of the same cross-sectional cut of the device (100) shown in Fig. 1A, with some of the features of Fig. 1A omitted for the purposes of illustration. Fig. 1C also shows the same cross-sectional cut of the device (100) shown in Fig. 1A, with some additional features. These additional features have been omitted in Fig. 1A for the purpose of illustration. Fig. 1D shows a top view of a device (100) of Fig. 1A

Fig. 1A shows a device (100) that comprises a waveguide (101) adapted and arranged for the propagation of electromagnetic waves. The device (100) also comprises a first element (102) and a second element (103) arranged in the form of layers. The first element (102) is in electrical connection with a first electrical contact (111), and the second element (103) is in electrical connection with a second electrical contact (112). The device (100) further comprises a further element (109) and an even-further element (110), also arranged in the form of layers. As shown in Fig. 1D, the further element (109) is in electrical connection with a third electrical contact (113), while the even-further element (110) is in electrical connection with a fourth electrical contact (114). The first element (102) is separated from the even-further element (110) by a further gap (117). Similarly, the second element (103) is separated from the further element (109) by a first gap (115). Fig. 1A further shows that a first layer of the first kind (121) is arranged between the first element (102) and the second element (103).

Fig. 1A further shows that the first element (102) and the even-further element (110) are arranged at the same height (measured along the *y*-axis), and that the second element (103) and the further element (109) are arranged at the same height. While this is preferred, this is not required. The first element (102) and the even-further element (110) can also be arranged at different heights. Similarly, the second element (103) and the further element (109) can also be arranged at different heights.

As shown in Fig. 1B, the first element (102) and the second element (103) are arranged such that a first section (104) of the first element (102) and a first section (105) of the second element (103) overlap, a further section (106) of the first element (102) and the second element (103) do not overlap, and a further section (107) of the second element (103) and the first element (102) do not overlap. As also shown in Fig. 1B, the further element (109) and the further section (106) of the first element (102) are arranged to overlap, and the even-further element (110) and the further section (107) of the second element (103) are arranged to overlap. The first section (104) of the first element (102) and the first section (105) of the second element (103) are separated by a first distance (108), the further element (109) and the further section (106) of the first element (102) are separated by a second distance (119), and the even-further element (110) and the further section (107) of the second element (103) are separated by a third distance (120). Fig. 1B also shows how a width (116) of the first gap (115) and a width (118) of the further gap (117) is measured.

The first element (102), the second element (103), the first electrical contact (111), and the further electrical contact (112) are adapted and arranged such that the first section (104) of the first element (102) and the first section (105) of the second element (103) can be electrically charged and discharged. When the first section (104) of the first element (102) and the first section (105) of the second element (103) are electrically charged, a first potential difference (and thus electric field) is present between the first section (104) of the first element (102) and the first section (105) of the second element (103). It is preferred that the first potential difference can be varied by at least 10 % over a time interval of 1 ns. The further element (109) and the third electrical contact (113) are adapted and arranged to electrically charge the further element (109) in order to create a second potential difference (and thus an electric field) between the further element (109) and the further section (106) of the first element (102). The further element (109) and the third electrical contact (113) are further adapted and arranged to vary the second potential difference by less than 10 % over a time interval of 1 s. Similarly, the even-further element (110) and the fourth electrical contact (114) are adapted and arranged to electrically charge the even-further element (110) in order to create a third potential difference (and thus an electric field) between the even-further element (110) and the further section (107) of the second element (103). The even-further element (110) and the fourth electrical contact (114) are further adapted and arranged to vary the third potential difference by less than 10 % over a time interval of 1 s.

Fig. 1C shows that a further layer of the first kind (122) is arranged between the first element (102) and the waveguide (101). Fig. 1C also shows that an even-further layer of the first kind (123) is arranged below the second element (103). While not shown in Figs 1A to 1D, another layer of the first kind may also be arranged between the even-further layer of the first kind (123) and the second element (103).

For the device (100) in Fig. 1 it is preferred that the first element (102), the second element (103), the further element (109), and the even-further element (110) comprise, more preferably is made of, graphene. However, it is not required that all of the aforementioned elements comprise graphene. It is, however, particularly preferred that at least the first element (102) comprises, more preferably is made of, graphene.

Fig. 1D shows the device (100) from above. The cross-section cut of the device, shown in Figs 1A to 1C, is made at a position 124. The cut is made perpendicular to the direction of propagation of the electromagnetic waves through the waveguide (101), which is along the z-axis. For the purposes of illustration, a further layer of the first kind (122) is not shown in Fig. 1D.

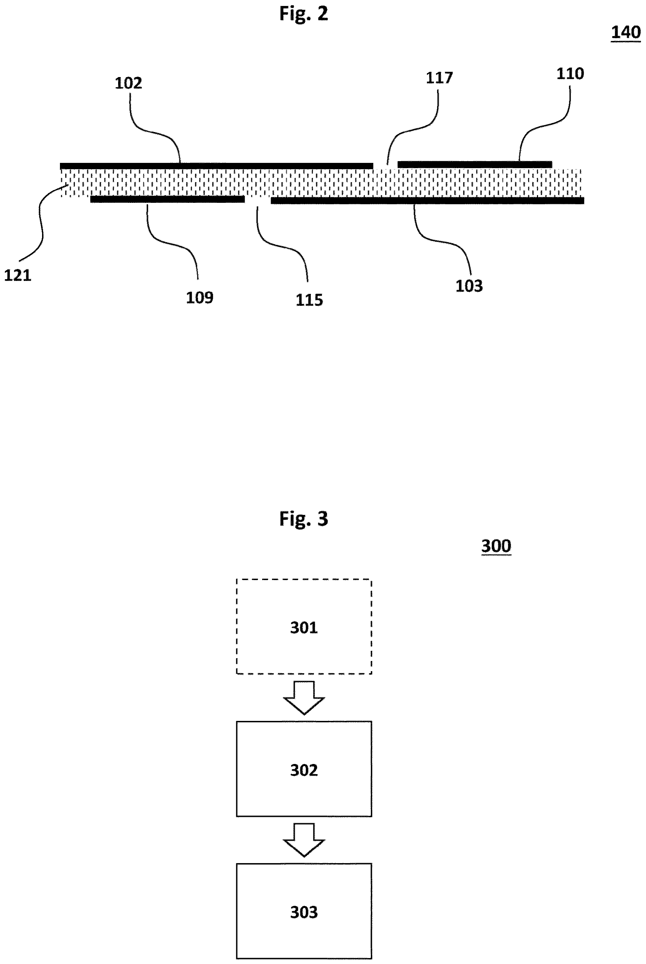

Fig. 2 shows a cross-sectional cut of a structure (140) according to the invention. The structure (140) comprises a first element (102), a second element (103), a further element (109), an even-further element (110), and a first layer of the first kind (121) that are adapted and arranged as discussed in Figs 1A to 1D. For example, a first gap (115) is present between the second element (103) and the further element (109), while a further gap (117) is present between the first element (102) and the even-further element (110).

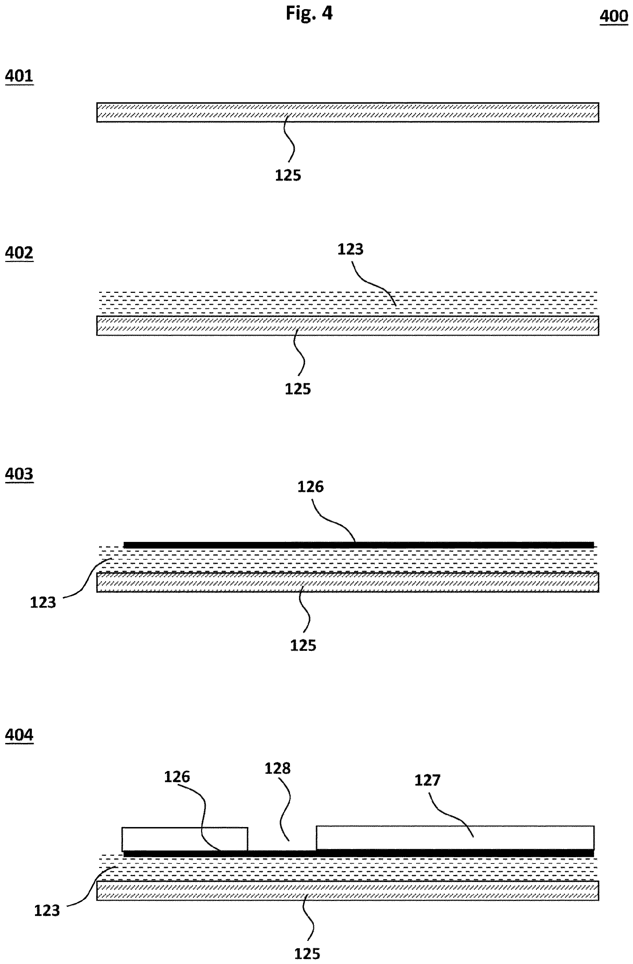

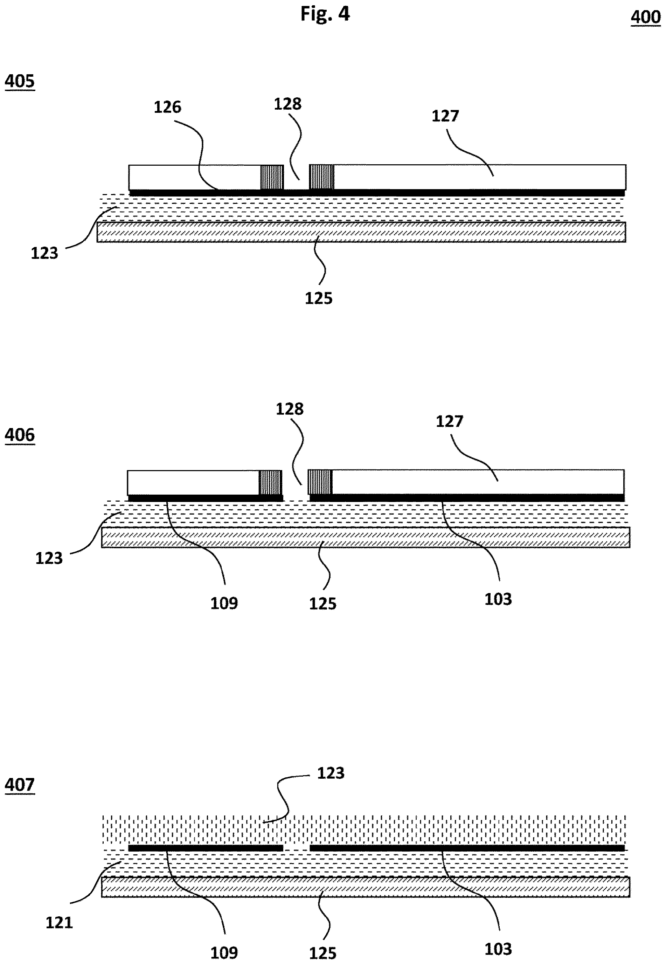

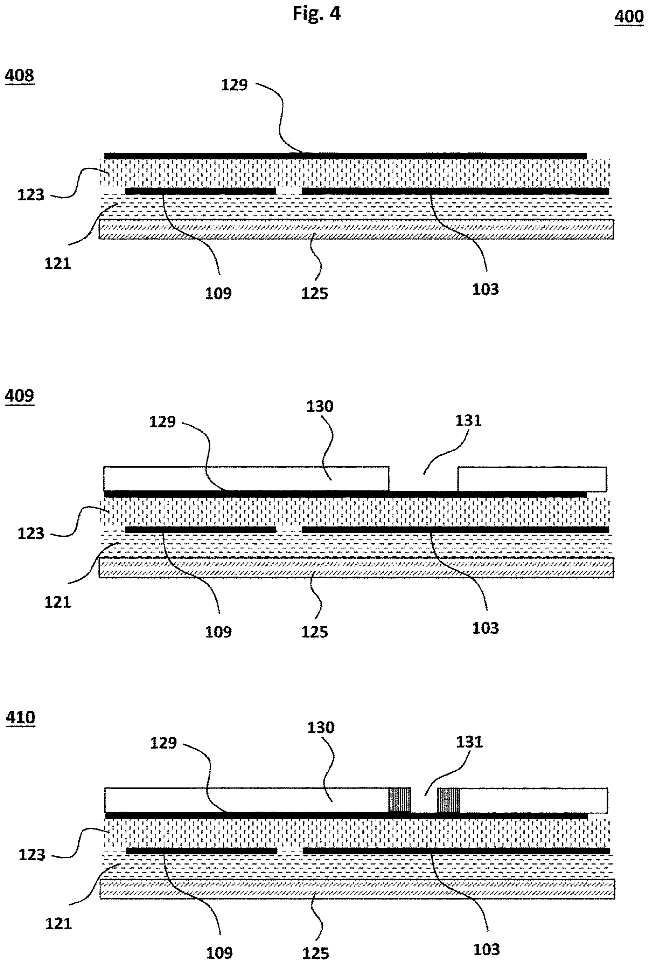

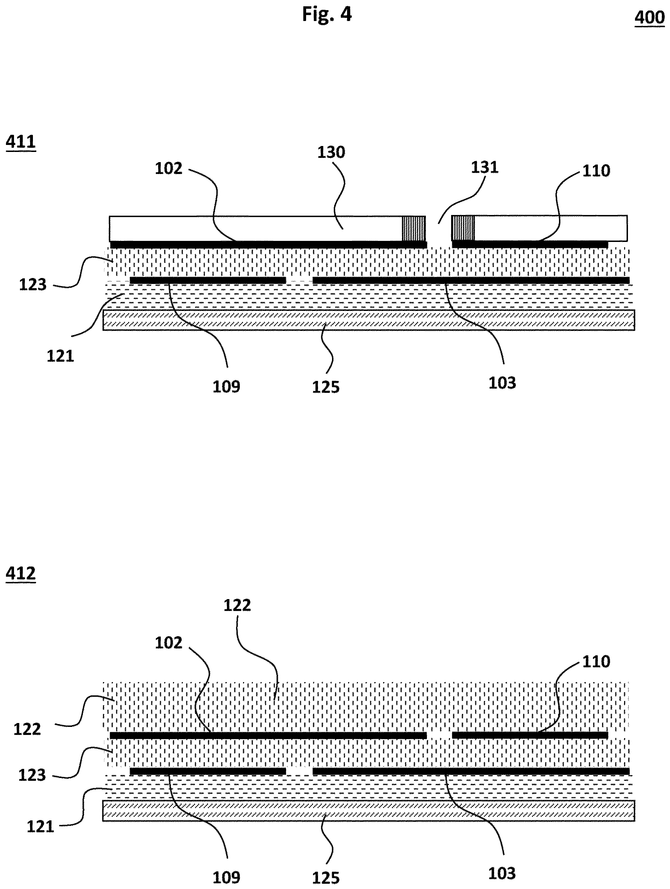

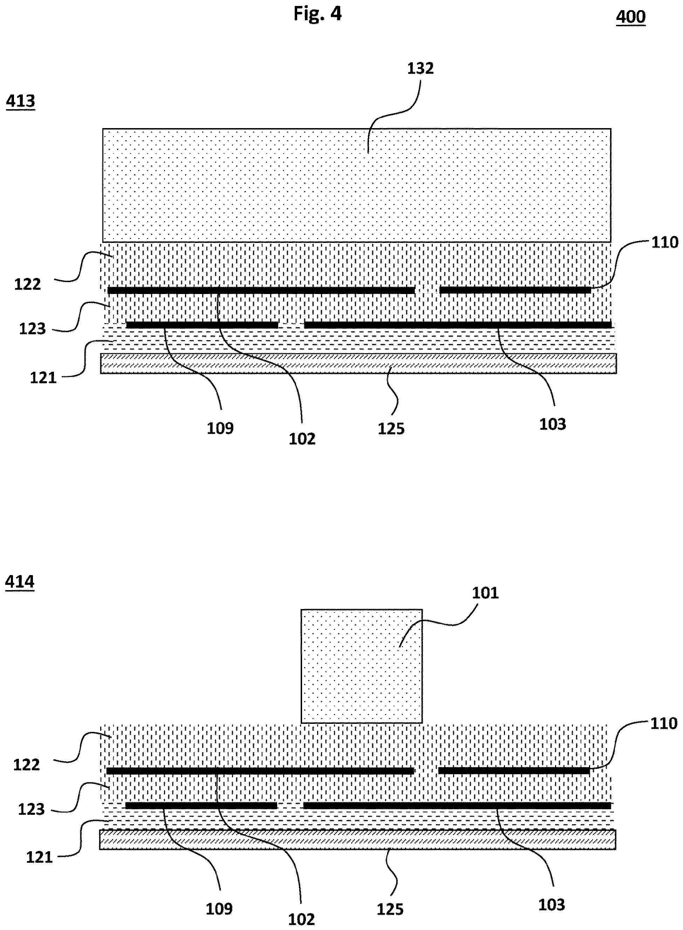

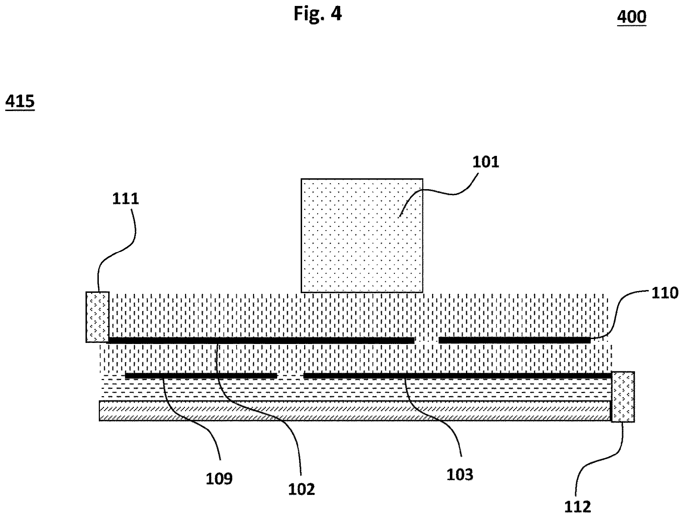

Fig. 3 shows a flow diagram illustrating the steps of a first method (300) for producing a device according to the invention. In step 302, a structure (140) according to Fig. 2 is provided. The structure can be provided by obtaining the structure, *e.g.*, by purchasing the structure. Alternative, the structure can be provided by manufacturing the structure, *e.g.*, as described in steps 403 to 411 of Fig. 4. In step 303 a waveguide and the structure are superimposed onto each other. The waveguide can be superimposed on the structure by manufacturing the waveguide, *e.g.*, as described in steps 413 to 414 of Fig. 4, or can be superimposed as a completed product that was obtained by, *e.g.*, purchasing.

Alternatively, the waveguide can be provided in step 301 by obtaining the waveguide, *e.g.*, by purchasing the waveguide. Alternative, the waveguide can be provided in step 301 by manufacturing the waveguide, *e.g.*, as described in steps 413 to 414 of Fig. 4. When the waveguide is provided in step 301, the structure can be provided (step 302) by obtaining the structure, *e.g.*, by purchasing the structure. Alternative, the structure can be provided by manufacturing the structure, *e.g.*, as described in steps 403 to 411 of Fig. 4. In this case, the step 302 of providing the structure and the step 303 of superimposing the structure and the waveguide are performed as a single, combined step.

Fig. 4 shows a schematic illustration of a method (400) for producing a device according to the invention.

In step 401, a first substrate layer (125) comprising $SiO_2$ is provided. The first substrate layer (125) can be provided using, *e.g.*, chemical vapour deposition, physical vapour deposition, and atomic layer deposition, al alternatively by purchasing the first substrate layer (125).

In optional step 402, an even-further layer of the first kind (123) is superimposed on the first substrate layer (125). The even-further layer of the first kind (123) can be superimposed on the first substrate layer (125) using, *e.g.*, chemical vapour deposition, physical vapour deposition, and atomic layer deposition.

In step 403, a further pre-element (126), in the form of a graphene layer, is superimposed on the even-further layer of the first kind (123). The further pre-element (126) can be superimposed on the even-further layer of the first kind (123) by transferring the further pre-element (126), *e.g.*, from a further substrate. Alternatively, the further pre-element (126) can be superimposed on the even-further layer of the first kind (123) using chemical vapour deposition. Alternatively, the further pre-element (126) can be obtained using exfoliation and superimposing the further pre-element (126) on the even-further layer of the first kind (123).

In optional step 404, a first layer of a further kind (127), *e.g.*, a photoresist, is superimposed on the further pre-element (126). Using *e.g.*, lithography, a first slit (128) is made in the photoresist to expose a section of the further pre-element (126) (*i.e.*, a section of the photoresist is removed).

In optional step 405 a width of the first slit (128) in the first layer of a further kind (127) is reduced. The width of the first slit (128) can be reduced by using atomic layer deposition.

In step 406, the further pre-element (126) is divided into a second element (103) and a further element (109) using *e.g.*, ion milling or reactive ion etching. If the first layer of a further kind (127) is present, the division is made at the position of the first slit (128) by directing an energy beam (*e.g.*, an ion beam) through the first slit (128). Once division has been completed, the first layer of a further kind (127) is removed, if present. This removal includes the removal of material that was used to reduce the width of the slit (128).

In step 407, a first layer of the first kind (121) is superimposed on the second element (103) and the further element (109) using, *e.g.*, chemical vapour deposition, physical vapour deposition, and atomic layer deposition.

In step 408, a first pre-element (129), in the form of a graphene layer, is superimposed on the first layer of the first kind (121). The superimposing of the first pre-element (129) is the same as described in step 403 for the further pre-element (126).

In optional step 409, a further layer of a further kind (130), *e.g.*, a photoresist, is superimposed on the first pre-element (129). Using *e.g.*, lithography, a further slit (131) is made in the photoresist to expose a section of the first pre-element (129) (*i.e.*, a section of the photoresist is removed).

In optional step 410 a width of the further slit (131) in the further layer of a further kind (130) is reduced. The width of the further slit (131) can be reduced as described in step 405.

In step 411, the first pre-element (129) is divided into a first element (102) and an even-further element (110). The separation can be made using *e.g.*, ion milling or reactive ion etching. If the further layer of a further kind (130) is present, the division is made at the position of the further slit (131) by directing an energy beam (*e.g.*, an ion beam) through the further slit (131). Once division has been completed, the further layer of a further kind (130) is removed, if present. This removal includes the removal of material that was used to reduce the width of the slit (131).

In optional step 412, a further layer of the first kind (122) is superimposed on the first element (102) and the even-further element (110) using, *e.g.*, chemical vapour deposition, physical vapour deposition, and atomic layer deposition.

In step 413, a waveguide layer (132) is superimposed on the first element (102) and the even-further element (110) (or the further layer of the first kind (122) if it is present).

In step 414, the waveguide layer (132) is subjected to, *e.g.*, lithography and/or reactive ion etching, to obtain the waveguide (101).

In step 415, a first electrical contact (111), a second electrical contact (112), a third electrical contact (113), and a fourth electrical contact (114) are brought into electrical connection with the first element (102), the second element (103), the further element (109) and the even-further element (110).

As an alternative to the method shown in Fig. 4, steps 414 and 415 are performed prior to step 402. In other words, the waveguide layer (132) is deposited on the first substrate layer (125). Once the waveguide (101) has been obtained from the waveguide layer (132), the even-further layer of the first kind (123) is optionally superimposed in the waveguide (101).

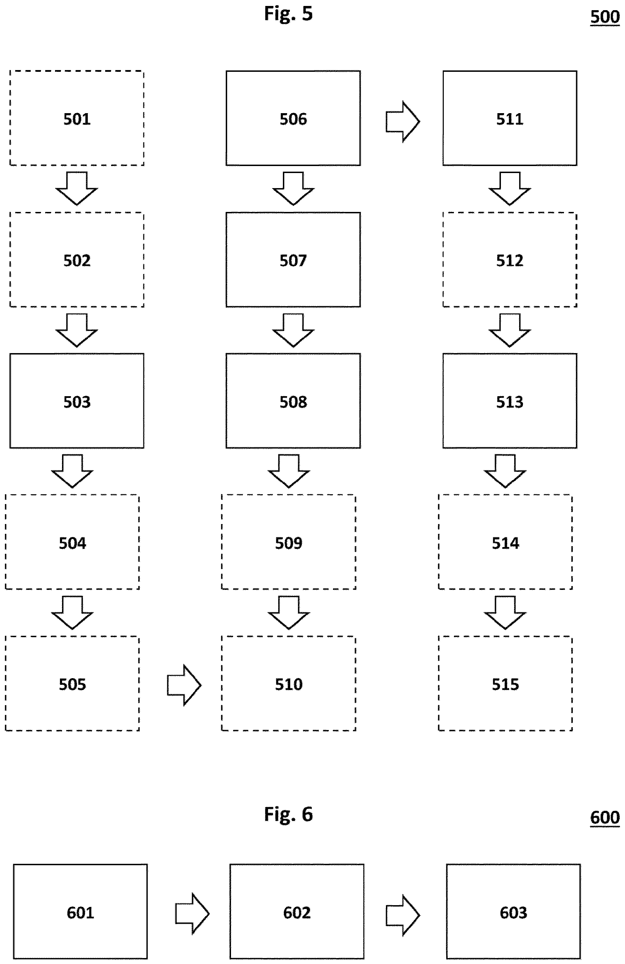

Fig. 5 shows a flow diagram illustrating the steps of a second method (500) for producing a device according to the invention:

Step 501: optionally, proving a first substrate layer.

Step 502: optionally, providing an even-further layer of the first kind. If the first substrate layer is present, the an even-further layer of the first kind is superimposed on the first substrate layer.

Step 503: providing a further pre-element. If the even-further layer of the first kind is present, the further pre-element is superimposed on the even-further layer of the first kind. If the first substrate layer is present, and the even-further layer of the first kind is not present, the further pre-element is superimposed on the first substrate layer.

Step 504: optionally superimposing a first layer of a further kind on the further pre-element and providing at least one recess in the first layer of the further kind by removing at least one section of the first layer of a further kind, preferably to expose the further pre-element.

Step 505: optionally reducing at least one dimensions, preferably a width, of the at least one recess in the first layer of the further kind.

Step 506: dividing the further pre-element into a second element and a further element.

Step 507: superimposing a first layer of the first kind onto the second element and the further element.

Step 508: superimposing a first pre-element onto the first layer of the first kind.

Step 509: optionally superimposing a further layer of a further kind on the first pre-element and providing at least one recess in the further layer of the further kind by removing at least one section of the further layer of a further kind, preferably to expose the first pre-element.

Step 510: optionally reducing at least one dimensions, preferably a width, of the at least one recess in the further layer of the further kind.

Step 511: dividing the first pre-element into a first element and an even-further element.

Step 512: optionally, superimposing a further layer of the first kind onto the first element and the even-further element.

Step 513: superimposing a waveguide layer onto the first element and the even-further element.

Step 514: optionally, removing at least a section of the waveguide layer to obtain a waveguide. If no section is removed, the waveguide layer serves as a waveguide.

Step 515: optionally, performing at least one or all of the following: bringing a first electrical contact into electrical connection with the first element, bringing a second electrical contact into electrical connection with the second element, bringing a third electrical contact into electrical connection with the further element, bringing a second electrical contact into electrical connection with the even-further element.

In one variation of the method described in Fig. 5, the first pre-element provided in step 508 is the first element. In this variation, step 511 is not performed, and the device does not comprise an even-further element. In another variation of the method described in Fig. 5, steps 513 and 514 are performed after step 501, *i.e.,* the waveguide layer is provided on the first substrate layer. The optionally provided even-further layer of the first kind in steps 502 is thus provided on the waveguide. Steps and optional steps 503 to 512, and 515 are then subsequently performed.

Fig. 6 shows a flow diagram illustrating the steps of a method (600) for producing an electromagnetic wave with at least one modified property.

In step 601, a device according to Fig. 1 is provided. In step 602, an electromagnetic wave is propagated through the waveguide. Furthermore, in step 602, a first potential difference is applied between the first section of the first element and the first section of the second element, a second potential difference between the further section of the first element and the further element, and a third potential difference is applied between the further section of the further element and the even-further element. In step 603, the first potential is oscillated between a minimum and maximum value over a time interval. During the same time interval, the second potential and the third potential are varied less slowly than the first potential difference. It is preferred to keep the second and third potential differences constant.

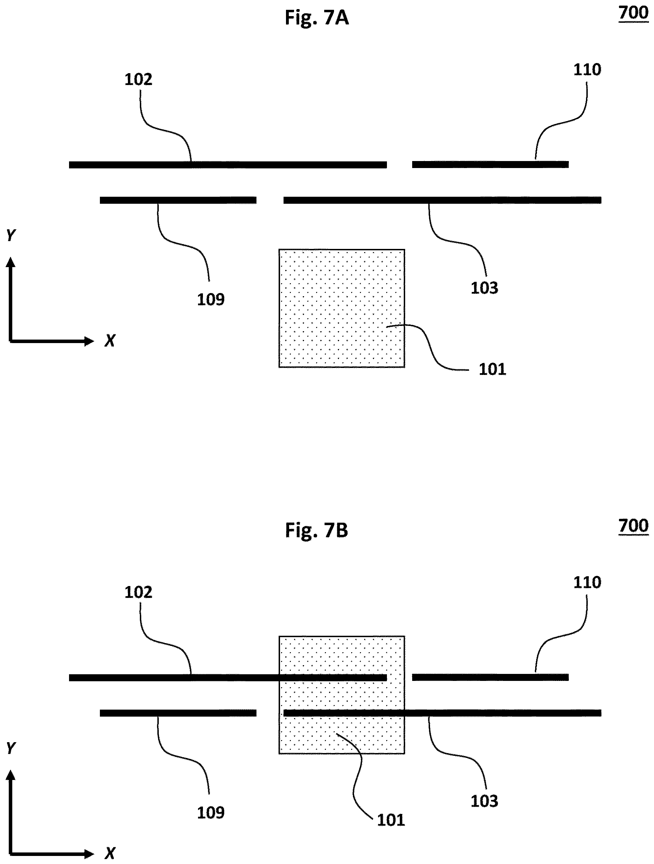

Fig. 7 shows examples of alternative arrangements (700) of the waveguide and the elements of the device, according to the invention, to the arrangement shown in Figs 1A to 1D. For illustration purposes, only the elements and waveguide are shown in Figs 7A and 7B. However, the devices in Figs 7A and 7B may comprise the same components as shown in Figs 1A to 1D.

Fig. 7A shows a waveguide (101) that is arranged below the first element (102), a second element (103), the further element (109), and the even-further element (110). Fig. 7B shows that the first element (102) and the second element (103) are arranged to pass through the waveguide (101).

## EXAMPLES

The invention is illustrated further by way of examples. The invention is not restricted to the examples.

Example 1

Devices for the modulation of electromagnetic waves are provided. The differences between the devices of examples 1 to 3 are as follows:

- Example 1.1 a device as shown in Fig. 1 is provided, with the difference that the further element and the even-further element are absent. Example 1.1 is a comparative example.
- Example 1.2: a device as shown in Fig. 1 is provided, with the difference that the device has only the further element, while the even-further element is absent. Example 12 is an inventive example.
- Example 1.3: a device as shown in Fig. 1 is provided. Example 1.3 is an inventive example.

For each of these devices of examples 1 to 3, the following applies. Each device comprises an even-further layer of the first kind (123 in Fig. 1C) that is made of silicon dioxide. Arranged between the first element and a second element is a first layer of the first kind (121 in Fig. 1A and 1C), which is made from aluminium oxide. Arranged between the first element (and the even-further element) and the waveguide is a further layer of the first kind (122 in Fig. 1A and 1C), which is also made from aluminium oxide. Furthermore, the devices have a first element and a second element that are both made from graphene. Where a further element or a further element and an even-further element are present, these elements are also made from graphene. The waveguide is made from silicon nitride. The parameters of the examples are chosen such that optical modulation amplitude remains constant between the different devices of the examples.

For each of these devices of examples 1 to 3, the following also applies. The width and height of the waveguide is 1000 nm and 350 nm, respectively. For the respective examples, the second distance and the third distance are equal to the first distance. The length of the device also corresponds to the length of the first element, the second element, where present the further element, and where present, the even-further element. The biasing voltage is applied between the first sections of the first element and the second element. The other parameters are given in Table 1. The reference numbers are with respect to Figs 1A to 1D.

**Table 1:** experimental set-up of the examples 1.1 to 1.3

| Example | 1.1 | 1.2 | 1.3 |
|---|---|---|---|
| | | | |
| *Width* | | | |
| First element: first section (104) | 660 nm | 405 nm | 180 nm |
| First element: further section (106) | 1170 nm | 1297.5 nm | 1410 nm |
| Second element: first section (105) | 660 nm | 405 nm | 180 nm |
| Second element: further section (107) | 1170 nm | 1297.5 nm | 1410 nm |
| Further element (109) | | 1097.5 nm | 1210 nm |
| Even-further element (110) | | | 1210 nm |
| First gap (116) | | 100 nm | 100 nm |
| Further gap (118) | | | 100 nm |
| | | | |

(continued)

| Thickness/height | | | |
|---|---|---|---|
| First distance (108) | 40 nm | 20 nm | 20 nm |
| Further layer of the first kind (122) | 40 nm | 20 nm | 20 nm |
| | | | |
| Length of device | 55 μm | 60 μm | 90 μm |
| | | | |
| Biasing voltage | 12.3 V | 9.5 V | 6.4 V |

In the above, width is measured along the x-axis, height and thickness are measured along the *y*-axis, and length is measured along the z-axis, as shown in Fig. 1. The distance (first distance) between the first sections of the first element and the second element is measured along the *y*-axis, as shown in Figs 1A and 1D.

The devices of Examples 1.1 to 1.3 are operated. During operation, a first potential difference is applied between the first sections of the first element and the second element. If the further element is present, a second potential difference is applied between the further section of the first element and the further element. If the even-further element is present, a third potential difference is applied between the further section of the further element and the even-further element. Electromagnetic waves are propagated through the waveguide, while the first potential difference is varied by up to 2 V above and below the biasing voltage given in Table 1. The voltage variation is on a timescale of 2 ps to 1 ns. The first potential difference is driven to the desired value depending on the data that is desired to be sent. The second potential difference is kept constant at a value of 5 V and the third potential differences is kept constant at a value of -5 V.

Table 2 is a comparison of the technical effects of the devices of Example 1.

**Table 2:** comparison of technical effects

| **Technical effect** | **Example 1.1** | **Example 1.2** | **Example 1.3** |
|---|---|---|---|
| Bitrate [Gbps] | 30 | 49 | 135 |
| Insertion loss [dB] | 2.75 | 3.8 | 2.6 |
| Energy consumption [normalised] | 1 | 0.9 | 0.5 |

- Bitrate: the rate of data flow in digital networks, typically measured in bits per second. A "-" indicates a smaller bitrate, while a "+" indicates a larger bitrate. A larger bitrate is desirable.
- Insertion loss - unwanted loss in the intensity of the electromagnetic waves, *i.e.,* losses not as a result of the modulation. A "-" indicates a smaller insertion loss, while a "+" indicates a larger insertion loss. A smaller insertion loss is desirable.
- Energy consumption - the energy required to transmit one bit of data. A "-" indicates a smaller energy consumption, while a "+" indicates a larger energy consumption. A smaller energy consumption is desirable. The values in Table 2 are normalised with respect to Example 1.1.

## REFERENCE LIST

100    Device
101    Waveguide
102    First element
103    Second element
104    First section of first element
105    First section of second element
106    Further section of first element
107    Further section of second element
108    First distance

| | |
|---|---|
| 109 | Further element |
| 110 | Even-further element |
| 111 | First electrical contact |
| 112 | Second electrical contact |
| 113 | Third electrical contact |
| 114 | Fourth electrical contact |
| 115 | First gap |
| 116 | Width of first gap |
| 117 | Further gap |
| 118 | Width of further gap |
| 119 | Second distance |
| 120 | Third distance |
| 121 | First layer of the first kind |
| 122 | Further layer of the first kind |
| 123 | Even-further layer of the first kind |
| 124 | Position of cross-sectional cut |
| 125 | First substrate layer |
| 126 | Further pre-element |
| 127 | First layer of a further kind |
| 128 | First slit |
| 129 | First pre-element |
| 130 | Further layer of a further kind |
| 131 | Further slit |
| 132 | Waveguide layer |
| 140 | Structure |

**Claims**

1. A device (100) comprising

   a. a waveguide (101) adapted and arranged for the propagation of electromagnetic waves;
   b. a first element (102) and a second element (103)

      i. wherein, in a cross-sectional cut of the device (100), the first element (102) and the second element (103) are arranged such that

         A. a first section (104) of the first element (102) overlaps a first section (105) of the second element (103),
         B. a further section (106) of the first element (102) does not overlap the second element (103),
         C. the first section (104) of the first element (102) is separated by a first distance (108) from the first section (105) of the second element (103);

      ii. wherein the first section (104) of the first element (102) and the first section (105) of the second element (103) are adapted and arranged to be electrically charged and discharged;

   c. a further element (109), wherein, in the cross-sectional cut of the device (100), the further element (109) is arranged to overlap the further section (106) of the first element (102);
   d. optionally an even-further element (110), wherein, in the cross-sectional cut of the device (100), the even-further element (110) is arranged to overlap a further section (107) of the second element (103).

2. The device according to any of the preceding claims, wherein the first section (104) of the first element (102) and the first section (105) of the second element (103) is adapted and arranged to have an RC time constant that is less than 50 ns.

3. The device according to any of the preceding claims, wherein at least one or all of the following applies:

   a. the first section (104) of the first element (102), the further section (106) of the first element (102), or both, comprises graphene;

b. the first section (105) of the second element (103), a further section (107) of the second element (103), or both, comprises graphene.

4. The device according to any of the preceding claims, wherein the further element (109), the even-further element (110), or both, are adapted and arranged to be electrically charged, electrically discharged, or both.

5. The device according to any of the preceding claims, wherein the further element (109), the even-further element (110), or both, have at least one or all of the following properties:

a. an electrical conductivity of at least $10^4$ S/m;
b. comprises graphene;
c. are adapted and arranged to have an optical attenuation coefficient in the range of $2 \times 10^{-4}$ to 0.6 dB/$\mu$m;
d. are adapted and arranged to have a variable optical attenuation coefficient.

6. The device according to any of the preceding claims, wherein at least one or all of the following applies:

a. the first element (102) and the second element (103) are adapted and arranged to produce a first potential difference between the first section (104) of the first element (102) and the first section (105) of the second element (103);
b. the first element (102) the further element (109) are adapted and arranged to produce a second potential difference between the further section (106) of the first element (102) and the further element (109);
c. optionally the second element (103) and the even-further element (110) are adapted and arranged to produce a third potential difference between the further section (107) of the second element (103) and the even-further element (110)

7. The device according to claim 6, wherein the first section (104) of the first element (102) and the first section (105) of the second element (103) are adapted and arranged for at least one or all of the following:

a. to vary the first potential difference by at least 5 % over a time interval of 0.05 ps to 70 ns;
b. to vary the second potential difference by less than 15 % over a time interval of at least 100 ps.

8. The device according to any of the preceding claims, wherein at least one or all of the following applies:

a. the further element (109) is arranged such that a first gap (115) is formed between the further element (109) and the second element (103);
b. the even-further element (110) is arranged such that a further gap (117) is formed between the first element (102) and the even-further element (110).

9. A method for producing a device comprising the steps

a. providing a structure (140) that comprises

i. a first element (102) and a second element (103),

A. wherein, in a cross-sectional cut of the structure (140), the first element (102) and the second element (103) are arranged such that

I. a first section (104) of the first element (102) overlaps a first section (105) of the second element (103),
II. a further section (106) of the first element (102) does not overlap the second element (103),
III. the first section (104) of the first element (102) is separated by a first distance (108) from the first section (105) of the second element (103);

B. wherein the first section (104) of the first element (102) and the first section (105) of the second element (103) are adapted and arranged to be electrically charged and discharged;

ii. a further element (109), wherein, in the cross-sectional cut of the structure (140), the further element (109) is arranged to overlap the further section (106) of the first element (102);

iii. optionally an even-further element (110), wherein, in the cross-sectional cut of the structure (140), the even-further element (110) is arranged to overlap the further section (107) of the second element (103).

b. superimposing a waveguide (101) and the structure (140) onto each other.

**10.** A device obtainable according to claim 9.

**11.** A method for producing an electromagnetic wave with at least one modified property, comprising the steps of

a. providing a device according to any of the claims 1 to 8;
b. propagating an electromagnetic wave through the waveguide;
c. applying a first potential difference between the first section of the first element and the first section of the second element;
d. applying a second potential difference between the further section of the first element and the further element;

**12.** A modified electromagnetic wave obtained by the method according to claim 11.

**13.** A use of a potential difference to decrease an optical attenuation coefficient of at least one section of at least one element of a device that is adapted and arranged for modifying at least one property of electromagnetic waves, wherein the potential difference is varied by less than 15 % over a time interval of at least 100 ps.

**14.** A use of a device adapted and arranged for modifying at least one property of electromagnetic waves to decrease an optical attenuation coefficient of at least one section of at least one element of the device using a potential difference that is varied by less than 15 % over a time interval of at least 100 ps.

**15.** Use of a structure (140) for producing an opto-electronic device, wherein the structure comprises

a. a first element (102) and a second element (103)

i. wherein, in a cross-sectional cut of the structure (140), the first element (102) and the second element (103) are arranged such that

A. a first section (104) of the first element (102) overlaps a first section (105) of the second element (103),
B. a further section (106) of the first element (102) does not overlap the second element (103),
C. the first section (104) of the first element (102) is separated by a first distance (108) from the first section (105) of the second element (103);

ii. wherein the first section (104) of the first element (102) and the first section (105) of the second element (103) are adapted and arranged to be electrically charged and discharged;

b. a further element (109), wherein, in the cross-sectional cut of the structure (140), the further element (109) is arranged to overlap the further section (106) of the first element (102);
c. optionally an even-further element (110), wherein, in the cross-sectional cut of the structure (140), the even-further element (110) is arranged to overlap a further section (107) of the second element (103).

**Fig. 1A**

**Fig. 1B**

## Fig. 1C

100

## Fig. 1D

100

**Fig. 2**

140

102    117    110

121    109    115    103

**Fig. 3**

300

301

302

303

# Fig. 4

**400**

**401**

**125**

**402**

**123**

**125**

**403**

**126**

**123**

**125**

**404**

**126**
**128**
**127**

**123**

**125**

# Fig. 4

**400**

**405**

126    128    127

123

125

**406**

128    127

123

109    125    103

**407**

123

121

109    125    103

## Fig. 4 $\qquad$ <u>400</u>

<u>408</u>

129

123

121

109    125    103

<u>409</u>

130

129    131

123

121

109    125    103

<u>410</u>

130

129    131

123

121

109    125    103

**Fig. 4** <u>400</u>

<u>411</u>

<u>412</u>

# Fig. 4

**413**

132

110

122

123

121

109

102

125

103

**414**

101

110

122

123

121

109

102

125

103

**Fig. 4**

<u>400</u>

<u>415</u>

**Fig. 5**                                                                                      500

```
┌ ─ ─ ─ ─ ─ ─ ┐        ┌─────────────┐           ┌─────────────┐
┊     501     ┊        │     506     │    ▷      │     511     │
└ ─ ─ ─ ─ ─ ─ ┘        └─────────────┘           └─────────────┘
      ▽                      ▽                         ▽
┌ ─ ─ ─ ─ ─ ─ ┐        ┌─────────────┐           ┌ ─ ─ ─ ─ ─ ─ ┐
┊     502     ┊        │     507     │           ┊     512     ┊
└ ─ ─ ─ ─ ─ ─ ┘        └─────────────┘           └ ─ ─ ─ ─ ─ ─ ┘
      ▽                      ▽                         ▽
┌─────────────┐        ┌─────────────┐           ┌─────────────┐
│     503     │        │     508     │           │     513     │
└─────────────┘        └─────────────┘           └─────────────┘
      ▽                      ▽                         ▽
┌ ─ ─ ─ ─ ─ ─ ┐        ┌ ─ ─ ─ ─ ─ ─ ┐           ┌ ─ ─ ─ ─ ─ ─ ┐
┊     504     ┊        ┊     509     ┊           ┊     514     ┊
└ ─ ─ ─ ─ ─ ─ ┘        └ ─ ─ ─ ─ ─ ─ ┘           └ ─ ─ ─ ─ ─ ─ ┘
      ▽                      ▽                         ▽
┌ ─ ─ ─ ─ ─ ─ ┐        ┌ ─ ─ ─ ─ ─ ─ ┐           ┌ ─ ─ ─ ─ ─ ─ ┐
┊     505     ┊   ▷    ┊     510     ┊           ┊     515     ┊
└ ─ ─ ─ ─ ─ ─ ┘        └ ─ ─ ─ ─ ─ ─ ┘           └ ─ ─ ─ ─ ─ ─ ┘
```

**Fig. 6**                                                                                      600

```
┌─────────────┐        ┌─────────────┐           ┌─────────────┐
│     601     │   ▷    │     602     │    ▷      │     603     │
└─────────────┘        └─────────────┘           └─────────────┘
```

**Fig. 7A**                                                                 700

102                                                                          110

Y

X

109                                                      103

101

**Fig. 7B**                                                                 700

102                                                                          110

Y

X

109                            101                       103

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 663 766 B2 (UNIV GEORGE WASHINGTON [US]) 26 May 2020 (2020-05-26)<br>* claim 12 *<br>* paragraph [0007] *<br>* paragraph [0027] *<br>* paragraph [0045] *<br>* paragraph [0053] *<br>* paragraph [0055] *<br>* paragraph [0062] * | 1-15 | INV.<br>G02F1/00<br>G02F1/17 |
| A | YAO HAIYUN ET AL: "Frequency-dependent ultrasensitive terahertz dynamic modulation at the Dirac point on graphene-based metal and all-dielectric metamaterials",<br>CARBON, ELSEVIER OXFORD, GB,<br>vol. 184, 16 August 2021 (2021-08-16),<br>pages 400-408, XP086810350,<br>ISSN: 0008-6223, DOI:<br>10.1016/J.CARBON.2021.08.023<br>[retrieved on 2021-08-16]<br>* page 2, column 2, line 17 – line 18 * | 5 | |
| A | US 2018/004061 A1 (SOMMER THOMAS RADFORD [US] ET AL) 4 January 2018 (2018-01-04)<br>* paragraph [0006] *<br>* paragraph [0009] *<br>* paragraph [0025] – paragraph [0027] *<br>* paragraph [0032] *<br>* paragraph [0035] * | 1-15 | **TECHNICAL FIELDS SEARCHED (IPC)**<br><br>G02F |
| A | KR 2015 0023227 A (SONY CORP [JP])<br>5 March 2015 (2015-03-05)<br>* paragraph [0005] – paragraph [0007] *<br>* paragraphs [0108], [0109] * | 1-15 | |

-/--

The present search report has been drawn up for all claims

| Place of search | Date of completion of the search | Examiner |
|---|---|---|
| The Hague | 11 September 2023 | Votini, Stefano |

EPO FORM 1503 03.82 (P04C01)

## EUROPEAN SEARCH REPORT

Application Number

EP 23 16 9010

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/101247 A1 (CHO SEONG-HO [KR] ET AL) 25 April 2013 (2013-04-25)<br>* paragraph [0018] *<br>* paragraph [0035] *<br>* paragraph [0037] *<br>* paragraph [0040] *<br>* paragraph [0046] *<br>* paragraph [0059] – paragraph [0060] *<br>----- | 1–15 | |
| A | MING LIU ET AL: "Double-layer graphene optical modulator",<br>NANO LETTERS, AMERICAN CHEMICAL SOCIETY, US,<br>vol. 12, no. 3, 14 March 2012 (2012-03-14)<br>, pages 1482-1485, XP002687418,<br>ISSN: 1530-6984, DOI: 10.1021/NL204202K<br>[retrieved on 2012-02-14]<br>* abstract *<br>* figure 1 *<br>----- | 1–15 | |
| A | ELHAM HEIDARI ET AL: "Integrated ultra-high-performance graphene optical modulator",<br>ARXIV.ORG, CORNELL UNIVERSITY LIBRARY, 201 OLIN LIBRARY CORNELL UNIVERSITY ITHACA, NY 14853,<br>15 September 2021 (2021-09-15),<br>XP091056780,<br>* figure 1 *<br>----- | 1–15 | TECHNICAL FIELDS SEARCHED (IPC) |

The present search report has been drawn up for all claims

| Place of search | Date of completion of the search | Examiner |
|---|---|---|
| The Hague | 11 September 2023 | Votini, Stefano |

EPO FORM 1503 03.82 (P04C01)

## ANNEX TO THE EUROPEAN SEARCH REPORT
## ON EUROPEAN PATENT APPLICATION NO.

EP 23 16 9010

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2023

| Patent document cited in search report | | Publication date | Patent family member(s) | | Publication date |
|---|---|---|---|---|---|
| US 10663766 | B2 | 26-05-2020 | NONE | | |
| US 2018004061 | A1 | 04-01-2018 | US | 2018004061 A1 | 04-01-2018 |
| | | | WO | 2018005436 A1 | 04-01-2018 |
| KR 20150023227 | A | 05-03-2015 | JP | 6119121 B2 | 26-04-2017 |
| | | | JP | 2013257482 A | 26-12-2013 |
| | | | KR | 20150023227 A | 05-03-2015 |
| | | | TW | 201350969 A | 16-12-2013 |
| | | | US | 2015168747 A1 | 18-06-2015 |
| | | | WO | 2013186985 A1 | 19-12-2013 |
| US 2013101247 | A1 | 25-04-2013 | CN | 103064200 A | 24-04-2013 |
| | | | EP | 2584397 A1 | 24-04-2013 |
| | | | JP | 5980645 B2 | 31-08-2016 |
| | | | JP | 2013088810 A | 13-05-2013 |
| | | | KR | 20130042906 A | 29-04-2013 |
| | | | US | 2013101247 A1 | 25-04-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LIU et al.** A graphene-based broadband optical modulator. *Nature,* 2011, vol. 474, 65

- **LIU et al.** Double-layer graphene optical modulator. *Nano Letter,* 2012, vol. 12, 1482